# EUROPEAN PATENT SPECIFICATION

(11) **EP 3 817 524 B1**
(45) Date of publication and mention of the grant of the patent: **02.07.2025**
(21) Application number: 19827450.8
(22) Date of filing: 30.05.2019
(51) Int. Cl.: H05K 3/10, H05K 1/09, H05K 3/12

(54) **METHOD OF MANUFACTURING PRINTED WIRING BOARD**
VERFAHREN ZUR HERSTELLUNG EINER LEITERPLATTE
PROCÉDÉ DE FABRICATION D'UNE CARTE DE CIRCUIT IMPRIMÉ

(30) Priority: 26.06.2018 JP 2018120975
(43) Date of publication of application: 05.05.2021
(73) Proprietor: DIC Corporation, Tokyo 174-8520 (JP)
(72) Inventor: FUKAZAWA, Norimasa, Takaishi-shi, Osaka 592-0001 (JP); SHIRAKAMI, Jun, Takaishi-shi, Osaka 592-0001 (JP); FUJIKAWA, Wataru, Takaishi-shi, Osaka 592-0001 (JP); MURAKAWA, Akira, Takaishi-shi, Osaka 592-0001 (JP)
(74) Representative: TBK
(86) International application number: PCT/JP2019/021512
(87) International publication number: WO 2020/003878

(56) References cited:
- EP-A1- 2 833 705
- EP-A1- 2 916 627
- WO-A1-2013/146195
- WO-A1-2016/104249
- WO-A1-2018/030202
- CN-A- 108 048 842
- JP-A- 2004 172 427
- JP-A- 2006 303 368
- JP-A- 2010 272 837
- JP-A- 2013 084 680
- US-A1- 2012 031 656
- US-A1- 2018 147 815

## Description

### Technical Field

The present invention relates to a method for producing a printed wiring board.

### Background Art

In recent years, there is a need for thinner printed wiring boards (films) and finer-pitch circuit wiring as smaller and lighter electronic equipment products are demanded. A known and commonly used method for producing circuit wiring is the subtractive process, in which an etching resist in the shape of a circuit pattern is formed on the surface of a copper layer formed on an electrically insulating substrate, and then the copper layer in the area in which no circuit needs to be formed is etched to give copper wiring. The subtractive process, however, has some disadvantages. An example is that copper often remains in the skirting area of the wiring. If the wire-to-wire pitch is short because of an increased density of the circuit wiring, the copper residue causes short circuits and poor reliability of insulation between wires. Another is that further etching to prevent short circuits and to improve insulation reliability causes the thinning of the width of the wiring as a result of the etchant penetrating below the resist and thereby hastening side etching. In particular, if the wiring density varies from region to region, additional etching causes fine wiring present in the regions of low wiring density to be lost. The cross-sectional shape of the wiring obtained by the subtractive process, furthermore, is not rectangular but flared toward the substrate, e.g., trapezoidal or triangular. The wiring therefore has varying width along its thickness, and this makes the wiring unfavorable for use as lines for electrical transmission, too.

A proposed way to fabricate a fine-pitch wiring circuit while solving these problems is the semi-additive process. In the semi-additive process, an electrically conductive seed layer is formed on an electrically insulating substrate first, and then a plating resist is formed on the seed layer in the area in which no circuit is to be formed. After a wiring section is formed by electrolytic plating through the electrically conductive seed layer, the resist is peeled away, and the seed layer in the no-circuit area is removed to form the fine-pitch wiring. This method gives wiring having a rectangular cross-sectional shape because the plating is deposited to the shape of the resist. The wiring, moreover, is deposited to have the intended width regardless of the density or sparsity of the pattern. These make the semi-additive process suitable for the formation of fine-pitch wiring.

In the context of the semi-additive process, methods are known in which an electrically conductive seed layer is formed on an electrically insulating substrate by electroless copper plating or electroless nickel plating using a palladium catalyst. In these methods, the adhesion between the film substrate, for example if a build-up film is used, and the copper plating film is ensured by desmear. Desmear is the roughening of the surface of the substrate using a strong chemical such as permanganic acid, and the pores created are used as the starting point for the formation of the plating film. By taking advantage of the resulting anchoring effect, the adhesion between the electrically insulating substrate and the plating film is ensured. Roughening the surface of the substrate, however, causes problems such as difficulty in forming fine-pitch wiring and degraded transmission characteristics for radiofrequency waves. Reducing the degree of roughening has been under study, but gentle roughening is disadvantageous in that the adhesive strength between the wiring formed and the substrate is lower than needed.

A technology is also known in which an electrically conductive seed is formed by electroless nickel plating on a polyimide film. In this case, the polyimide film is immersed in a strong alkali to make the surface of the film hydrophilic by opening surface imide rings and at the same time to create there a modified layer into which water can penetrate. A palladium catalyst is allowed to penetrate into this modified layer, and in this state electroless nickel plating is carried out to form a nickel seed layer (e.g., see PTL 1.). In this technology, adhesive strength is achieved by using an outermost modified layer of polyimide as the starting point for the formation of nickel plating. The modified layer, however, contains open imide rings. This technology is therefore disadvantageous in that the modified layer makes the surface structure of the film physically and chemically weak.

A known method that involves no surface roughening or the formation of a surface modified layer to counter these is to form a nickel, titanium, or some other electrically conductive seed on an electrically insulating substrate by sputtering (e.g., see PTL 2.). This method does not require roughening the surface of a substrate to a seed layer, but is disadvantageous in that, for example, it requires a massive initial investment due to the need for expensive vacuum equipment, has limitations on the size and shape of the substrate, and is a complicated process that is of low productivity.

A proposed way to solve the problems with sputtering is to use a coating layer of an electrically conductive ink containing metal particles as an electrically conductive seed layer (e.g., see PTL 3.). Regarding this technique, a technology is disclosed in which an electrically insulating substrate in the form of film or sheet is coated with an electrically conductive ink in which metal particles having a diameter of 1 to 500 nm are dispersed. The substrate is then heated to fix the metal particles in the coating of the electrically conductive ink as a metal layer to the electrically insulating substrate and thereby to form the electrically conductive seed layer. The electrically conductive seed layer is then plated.

PTL 3 proposes patterning by the semi-additive process. In this method, however, as stated above, a wiring section is formed by electrolytic plating through an electrically conductive seed layer first. Then a resist is peeled away, and fine-pitch wiring is formed by removing the seed layer in the area in which no circuit is to be formed. A problem is that in the subsequent removal of the seed layer using an etchant, the conductor circuit, formed by the electroplating, is also etched, reducing the circuit width and the thickness of the wiring. In particular, if the seed layer and the conductor circuit are made of the same metal species, the decreases in circuit width and in the thickness of the wiring are significant because the conductor circuit section is etched together when the seed layer in the no-circuit area is removed. If the seed layer in the no-circuit area is a layer formed by metal particles, furthermore, an extra problem arises. In that case the seed layer tends to be more susceptible to etching, and excessive etching of the seed layer section results in undercuts that cause the conductor circuit to detach from the substrate.

### Citation List

### Patent Literature

PTL 1: International Publication No. 2009/004774
PTL 2: Japanese Unexamined Patent Application Publication No. 9-136378
PTL 3: Japanese Unexamined Patent Application Publication No. 2010-272837

Further, US 2018/147815 A1 discloses a substrate for a printed circuit board that includes a resin film and a metal layer stacked on at least one of surfaces of the resin film. WO 2018/030202 A1 discloses a laminate in which a primer layer, a metal layer made of metal nanoparticles, and a metal plating layer are successively layered onto a transparent substrate; and a metal mesh and a touch panel using the laminate. CN 108048842 A discloses an etching fluid for silver nanowire conducting film. EP 2833705 A1 discloses a conductive pattern including a conductive layer (A); a primer layer (B); and a substrate layer (C). EP 2916627 A1 discloses a method for producing a ceramic circuit board comprising the steps of bonding a metal sheet to a ceramic substrate via a brazing material containing Ag to form a bonded body; etching the bonded metal sheet to form a circuit pattern; and removing an unnecessary brazing material from the substrate provided with the circuit pattern, by etching with an acidic solution comprising carboxylic acid and/or carboxylate and hydrogen peroxide.

### Summary of Invention

### Technical Problem

The problem to be solved by the present invention is to provide a method for producing a printed wiring board whereby wiring can be obtained with high adhesiveness between its substrate and conductor circuit, few undercuts, and a rectangular cross-sectional shape good for use as circuit wiring without requiring treatment such as surface roughening with chromic acid or permanganic acid or the formation of a surface modified layer with an alkali and without the use of vacuum equipment.

### Solution to Problem

After extensive research to solve the above problem, the inventors found a method for producing a printed wiring board in which a silver-particle layer, containing a particular quantity of silver particles, is formed on an electrically insulating substrate, a circuit-pattern resist is formed on the silver-particle layer, a conductor circuit is formed by plating, then the resist is peeled away, and the silver-particle layer in the area in which no circuit has been formed is removed using an etchant. By this method, strongly adhering circuit wiring can be obtained without surface roughening, and wiring can be obtained with few undercuts and a good rectangular cross-sectional shape without the use of vacuum equipment. The present invention is based on these findings.

That is, the present invention provides a method for producing a printed wiring board having a circuit pattern on an electrically insulating substrate that includes step 1, forming a silver-particle layer (M1) in a range of 0.01 to 0.5 g/m² on an electrically insulating substrate (A); step 2, forming a patterned resist on the silver-particle layer (M1), the patterned resist being a resist patterned by removing a portion thereof in an area in which a circuit is to be formed; step 3, forming a conductor-circuit layer (M2) by electroless plating, or a combination of electroless and electrolytic plating, and the primary metal used to form the conductor-circuit layer (M2) is copper; and step 4, peeling away the patterned resist and removing, using an etchant, the silver-particle layer (M1) in an area in which no circuit has been formed, wherein the etchant contains a carboxylic acid and hydrogen peroxide as active ingredients and the proportions between the carboxylic acid and hydrogen peroxide in the mixture are in a range of 2 to 100 moles of hydrogen peroxide per mole of the carboxylic acid.

The present invention also provides a method for producing a printed wiring board having a circuit pattern on an electrically insulating substrate that includes step 1', forming a primer layer (B) on an electrically insulating substrate (A) and then forming a silver-particle layer (M1) in a range of 0.01 to 0.5 g/m² on the primer layer (B); step 2, forming a patterned resist on the silver-particle layer (M1), the patterned resist being a resist patterned by removing a portion thereof in an area in which a circuit is to be formed; step 3, forming a conductor-circuit layer (M2) by electroless plating, or a combination of electroless and electrolytic plating, and the primary metal used to form the conductor-circuit layer (M2) is copper; and step 4, peeling away the patterned resist and removing, using an etchant, the silver-particle layer (M1) in an area in which no circuit has been formed, wherein the etchant contains a carboxylic acid and hydrogen peroxide as active ingredients and the proportions between the carboxylic acid and hydrogen peroxide in the mixture are in a range of 2 to 100 moles of hydrogen peroxide per mole of the carboxylic acid. Advantageous Effects of Invention

The methods according to the present invention for producing a printed wiring board allow the manufacturer to produce a printed wiring board having circuit wiring that strongly adheres and has a good rectangular cross-sectional shape on various smooth substrates without using vacuum equipment. By using the technologies according to the present invention, therefore, manufacturers can provide high-density and high-performance printed wiring boards in different shapes and sizes at low cost. Thus the present invention has high industrial applicability in the field of printed wiring. The uses of printed wiring boards produced by the methods according to the present invention for producing a printed wiring board, furthermore, are not limited to ordinary printed wiring boards but also include various electronic components that have a patterned metal layer on the surface of a substrate. For example, the methods according to the present invention can also be applied to connectors, shields against electromagnetic waves, RFID and other antennas, and film capacitors. In addition, the purposes of use of the methods according to the present invention for producing a printed wiring board also include decorative plating that has a patterned metal layer on substrates of different shapes and sizes.

### Description of Embodiments

The present invention is a method for producing a printed wiring board having a circuit pattern on an electrically insulating substrate that includes step 1, forming a silver-particle layer (M1) in a range of 0.01 to 0.5 g/m² on an electrically insulating substrate (A); step 2, forming a patterned resist on the silver-particle layer (M1), the patterned resist being a resist patterned by removing the portion thereof in the area in which the circuit is to be formed; step 3, forming a conductor-circuit layer (M2) by electroless plating, or a combination of electroless and electrolytic plating, and the primary metal used to form the conductor-circuit layer (M2) is copper; and step 4, peeling away the patterned resist and removing, using an etchant, the silver-particle layer (M1) in the area in which no circuit has been formed, wherein the etchant contains a carboxylic acid and hydrogen peroxide as active ingredients and the proportions between the carboxylic acid and hydrogen peroxide in the mixture are in a range of 2 to 100 moles of hydrogen peroxide per mole of the carboxylic acid.

A more preferred embodiment of the present invention is a method for producing a printed wiring board having a circuit pattern on an electrically insulating substrate that includes step 1', forming a primer layer (B) on an electrically insulating substrate (A) and then forming a silver-particle layer (M1) in a range of 0.01 to 0.5 g/m² on the primer layer (B); step 2, forming a patterned resist on the silver-particle layer (M1), the patterned resist being a resist patterned by removing the portion thereof in the area in which the circuit is to be formed; step 3, forming a conductor-circuit layer (M2) by electroless plating, or a combination of electroless and electrolytic plating, and the primary metal used to form the conductor-circuit layer (M2) is copper; and step 4, peeling away the patterned resist and removing, using an etchant, the silver-particle layer (M1) in the area in which no circuit has been formed, wherein the etchant contains a carboxylic acid and hydrogen peroxide as active ingredients and the proportions between the carboxylic acid and hydrogen peroxide in the mixture are in a range of 2 to 100 moles of hydrogen peroxide per mole of the carboxylic acid.

Examples of materials for the electrically insulating substrate (A) used in step 1 or 1' of the present invention include polyimide resins, polyamide-imide resins, polyamide resins, polyethylene terephthalate resins, polybutylene terephthalate resins, polyethylene naphthalate resins, polycarbonate resins, acrylonitrile-butadiene-styrene (ABS) resins, polyarylate resins, polyacetal resins, polymethyl (meth)acrylate and other acrylic resins, polyvinylidene fluoride resins, polytetrafluoroethylene resins, polyvinyl chloride resins, polyvinylidene chloride resins, graft copolymers of vinyl chloride resins with acrylic resins, polyvinyl alcohol resins, polyethylene resins, polypropylene resins, urethane resins, cycloolefin resins, polystyrene, liquid-crystal polymers (LCPs), polyether ether ketone (PEEK) resins, polyphenylene sulfide (PPS), polyphenylene sulfone (PPSU), cellulose nanofiber, silicon, silicon carbide, gallium nitride, sapphire, ceramics, glass, diamond-like carbon (DLC), and alumina.

A resin substrate that contains a thermosetting resin and an inorganic filler is also suitable for use as the electrically insulating substrate (A). Examples of thermosetting resins include epoxy resins, phenolic resins, unsaturated imide resins, cyanate resins, isocyanate resins, benzoxazine resins, oxetane resins, amino resins, unsaturated polyester resins, allyl resins, dicyclopentadiene resins, silicone resins, triazine resins, and melamine resins. Examples of inorganic fillers include silica, alumina, talc, mica, aluminum hydroxide, magnesium hydroxide, calcium carbonate, aluminum borate, and borosilicate glass. In each of the categories of thermosetting resins and inorganic fillers, one material such as listed above or two or more in combination can be used.

As for the form of the electrically insulating substrate (A), a substrate made of a flexible material, a substrate made of a rigid material, and a substrate made of a rigid and flexible material can all be used. To be more specific, the electrically insulating substrate (A) may be a commercially available material shaped into a film, sheet, or plate or may be a material obtained by shaping a solution, melt, or liquid dispersion of a resin such as listed above into any shape. Alternatively, the electrically insulating substrate (A) may be a substrate produced by forming a material of a resin such as listed above on metal or some other electrically conductive material.

For the form of the electrically insulating substrate (A), a flat substrate, such as a film, sheet, or plate, may have a through hole, i.e., a hole running from one side to the other of the substrate. Alternatively, a multilayer substrate may have a structure in which its outer layer has a through hole, or the multilayer substrate as a whole may have a blind hole, a hole that reaches its inner-layer section. If the electrically insulating substrate (A) has a through hole, the two sides of the through hole can be electrically connected together through the below-described process according to the present invention for producing a printed wiring board. If the electrically insulating substrate (A) is a multilayer substrate and has a structure that includes a blind hole as a hole reaching the inner-layer section, outer and inner electrically conductive layers can be electrically connected together through the process according to the present invention for producing a printed wiring board.

Step 1 of a method according to the present invention for producing a printed wiring board is a step of forming a silver-particle layer (M1) in a range of 0.01 to 0.5 g/m² on the electrically insulating substrate (A). This silver-particle layer (M1) serves as a seed layer for plating when a conductor-circuit layer (M2) is formed by plating in step 3 described below. The silver-particle layer (M1) is a layer containing silver particles, but may contain metal particles other than silver particles. Examples of metal particles other than silver particles include particles of metals such as gold, platinum, palladium, ruthenium, tin, copper, nickel, iron, cobalt, titanium, indium, and iridium. One or more types of such metal particles, if used, can be used together with the silver particles. In the present invention, silver particles are essential metal particles because, for example, they are relatively inexpensive, their surface is not easily oxidized even when they are stored under atmospheric conditions, and they are highly active as a catalyst in the plating step described below.

If metal particles other than silver particles are contained, the percentage of the metal particles other than silver particles is not critical, provided they do not prevent the formation of the silver-particle layer (M1) or cause a problem in the electrolytic plating in step 3 described below. Preferably, the percentage of such metal particles is 5 parts by mass or less, more preferably 2 parts by mass or less, per 100 parts by mass of silver particles. This helps make the removal of this layer by etching in step 4 described below even easier.

An example of a method for forming the silver-particle layer (M1) is by coating the electrically insulating substrate (A) with a liquid dispersion of silver particles. It is not critical how to coat with the liquid dispersion of silver particles as long as a good silver-particle layer (M1) is formed; an appropriate method can be selected from various coating processes, for example according to the shape, size, and degree of rigidity or flexibility of the electrically insulating substrate (A) used. Specific examples of coating processes include gravure coating, offset coating, flexo coating, pad printing, gravure offset coating, relief printing, double-sided relief printing, screen printing, microcontact printing, reverse printing, air-doctor coating, blade coating, air-knife coating, squeeze coating, impregnated coating, transfer-roll coating, kiss coating, cast coating, spray coating, inkjet printing, die coating, spin coating, bar coating, and dip coating.

Coating of both sides of a film-, sheet-, or plate-shaped electrically insulating substrate (A) with the liquid dispersion of silver particles can be by any method that gives a good silver-particle layer (M1); an appropriate method can be selected from coating processes such as listed by way of example above. The silver-particle layer (M1) in this case may be formed on both sides of the electrically insulating substrate (A) simultaneously, or may be formed on one side of the electrically insulating substrate (A) first and then on the other side. If the electrically insulating substrate (A) is an article having a solid shape, processes such as spray coating, inkjet printing, and dip coating are suitable, although the manufacturer can select an appropriate method from coating processes such as listed by way of example above according to the size and shape of the article.

Before being coated with the liquid dispersion of silver particles, the electrically insulating substrate (A) may undergo a surface treatment for the purposes of improved coating with the liquid dispersion of silver particles and improved adhesion of the conductor-circuit layer (M2), formed in step 3, to the substrate. The surface treatment for the electrically insulating substrate (A) can be of any kind unless the treated surface is so rough that it causes a problem in the formation of a fine-pitch pattern or the issue of signal transmission loss; an appropriate method can be selected from various treatments. Examples of surface treatments for such purposes include UV treatment, gas-phase ozonation, liquid-phase ozonation, corona treatment, and plasma treatment. One such surface treatment or two or more in combination can be used.

After the electrically insulating substrate (A) is coated with the liquid dispersion of silver particles, the coating film is dried. This causes the solvent in the liquid dispersion of silver particles to evaporate, leaving a silver-particle layer (M1) on the electrically insulating substrate (A).

The drying temperature and the duration of drying can be selected according to the temperatures the substrate used can withstand and to be appropriate for the kind of solvent, described below, used in the liquid dispersion of silver particles, but preferably are in a range of 20°C to 350°C and in a range of 1 to 200 minutes for duration. More preferably, the temperature for this drying is in a range of 0°C to 250°C so that a strongly adhering silver-particle layer (M1) will be formed on the substrate.

After the drying, the electrically insulating substrate (A) with the silver-particle layer (M1) formed thereon may optionally be annealed to improve the adhesion between the electrically insulating substrate (A) and the silver-particle layer (M1). An appropriate annealing temperature and duration can be selected, for example according to the temperatures the substrate used can withstand and the productivity requirement, and annealing at 60°C to 350°C for a duration of 30 minutes to 2 weeks is enough. For annealing at a temperature of 60°C to 180°C, a duration of 30 minutes to 2 weeks is preferred. For annealing at 180°C to 350°C, it is preferred that the duration be approximately 30 minutes to 5 hours.

The drying may involve blowing air or may not involve blowing air. The drying may be carried out in the air, may be carried out in an atmosphere purged with or under a stream of an inert gas, such as nitrogen or argon, or may be carried out in a vacuum.

If the electrically insulating substrate (A) is a piece of film, sheet, or plate or an article having a solid shape, the drying can be by blowing air or carried out inside a drying oven, such as a temperature-controlled oven, as well as by air drying in the place where the coating is carried out. If the electrically insulating substrate (A) is a roll of film or a roll of sheet material, the drying can be by continuously moving the roll material inside an unheated or heated space placed after the coating step. Examples of heating methods for drying in this case include those involving an oven, a hot-air drying furnace, an infrared drying furnace, laser irradiation, microwaves, irradiation with light (a device that produces a flash of light), etc. One such heating method or two or more in combination can be used.

The amount of the silver-particle layer (M1) formed on the electrically insulating substrate (A) is between 0.01 and 0.5 g/m². Forming the silver-particle layer (M1) to an amount in this range ensures that the formation of a conductor-circuit layer (M2) by a plating step in step 3 described below is easy, and that the step of removal using an etchant in step 4 described below is also easy.

The amount of the silver-particle layer (M1) formed on the electrically insulating substrate (A) can be checked using known and commonly used analytical techniques, such as x-ray fluorescence spectrometry, atomic absorption spectrometry, and ICP spectrometry.

The silver-particle layer (M1) is basically an electrically non-conductive layer. This can be confirmed using, for example, a multimeter commercially available to general consumers. If the multimeter indicates no electrical continuity and is overloaded when measuring the resistance between two points 1 cm away from each other, it means the layer is electrically non-conductive. For example, an overload reading on FLUKE's "233 Remote Display Digital Multimeter" indicates that there is an electrical resistance of at least 40 MΩ at a distance of 1 cm.

Furthermore, to reduce the reflection of active light from the silver-particle layer (M1) during the below-described step of creating a circuit pattern on a resist layer by exposure to active light, the silver-particle layer (M1) may contain a light-absorbing pigment or dye that absorbs the active light, such as graphite, carbon, a cyanine compound, a phthalocyanine compound, a dithiol metal complex, a naphthoquinone compound, a diimmonium compound, or an azo compound, as a light absorber, provided that it does not prevent the formation of the silver-particle layer (M1) or cause a problem in the plating step in step 3 described below and that the layer can certainly be removed by etching in step 4 described below. An appropriate substance can be selected from such pigments and dyes according to the wavelength of the active light used. One such pigment or dye or two or more in combination can be used. The incorporation of such a pigment or dye into the silver-particle layer (M1) can be achieved simply by mixing the pigment or dye into the liquid dispersion of silver particles described below.

The liquid dispersion of silver particles used to form the silver-particle layer (M1) is a dispersion of silver particles in a solvent. The silver particles can be in any shape as long as they form a good silver-particle layer (M1); silver particles in various shapes can be used, such as spherical, lenticular, polyhedral, flat-plate, rod-shaped, and wire-shaped ones. One type of silver particles in a single shape or two or more types in different shapes can be used.

Spherical or polyhedral silver particles are preferably ones having an average diameter of 1 to 20,000 nm are preferred. If the circuit pattern to be formed is a fine-pitch one, particles having an average diameter of 1 to 200 nm are more preferred, even more preferably those having an average diameter of 1 to 50 nm. This further improves the homogeneity of the silver-particle layer (M1) and also helps make the removal of this layer using an etchant in step 4 described below even easier. Here, the "average diameter" in relation to particles of nanometer size is the volume-average diameter of the silver particles diluted in a good solvent for dispersion as measured by dynamic light scattering. This measurement can be done using Microtrac's "NANOTRAC UPA-150."

Lenticular, rod-shaped, wire-shaped, or similar silver particles are preferably ones having a minor axis of 1 to 200 nm, more preferably ones having a minor axis of 2 to 100 nm, even more preferably ones having a minor axis of 5 to 50 nm.

The silver particles are primarily silver, but may have part of the silver replaced with a different metal or may contain a non-silver metal component mixed therein unless it interferes with the plating step in step 3 described below or affects the removal of the silver-particle layer (M1) using an etchant in step 4 described below.

An example of a replacing or mixed metal is one or more metal elements selected from the group consisting of gold, platinum, palladium, ruthenium, tin, copper, nickel, iron, cobalt, titanium, indium, and iridium.

Preferably, the percentage of the replacing or mixed metal in the silver particles is 5% by mass or less. It is more preferred that this percentage be 2% by mass or less for easier plating and easier removal using an etchant of the silver-particle layer (M1).

The liquid dispersion of silver particles used to form the silver-particle layer (M1) is a dispersion of silver particles in any of various solvents. The silver particles in the liquid dispersion may have a monodisperse size distribution, i.e., may be uniform in size, or may be a mixture of groups of particles having an average diameter in any of the ranges indicated above.

The solvent in the liquid dispersion of silver particles can be an aqueous medium or organic solvent. Examples of aqueous media include distilled water, deionized water, purified water, and ultrapure water. Examples of organic solvents include alcohol compounds, ether compounds, ester compounds, and ketone compounds.

Examples of alcohol or ether solvents include methanol, ethanol, n-propanol, isopropyl alcohol, n-butanol, isobutyl alcohol, sec-butanol, tert-butanol, heptanol, hexanol, octanol, nonanol, decanol, undecanol, dodecanol, tridecanol, tetradecanol, pentadecanol, stearyl alcohol, allyl alcohol, cyclohexanol, terpineol or terpene alcohol, dihydroterpineol, 2-ethyl-1,3-hexanediol, ethylene glycol, diethylene glycol, triethylene glycol, polyethylene glycol, propylene glycol, dipropylene glycol, 1,2-butanediol, 1,3-butanediol, 1,4-butanediol, 2,3-butanediol, glycerol, ethylene glycol monomethyl ether, ethylene glycol monoethyl ether, ethylene glycol monobutyl ether, diethylene glycol monoethyl ether, diethylene glycol monomethyl ether, diethylene glycol monobutyl ether, tetraethylene glycol monobutyl ether, propylene glycol monomethyl ether, dipropylene glycol monomethyl ether, tripropylene glycol monomethyl ether, propylene glycol monopropyl ether, dipropylene glycol monopropyl ether, propylene glycol monobutyl ether, dipropylene glycol monobutyl ether, and tripropylene glycol monobutyl ether.

Examples of ketone solvents include acetone, cyclohexanone, and methyl ethyl ketone. Examples of ester solvents include ethyl acetate, butyl acetate, 3-methoxybutyl acetate, and 3-methoxy-3-methyl-butyl acetate. Other organic solvents can also be used, such as toluene and other hydrocarbon solvents, in particular hydrocarbon solvents having eight or more carbon atoms.

Examples of hydrocarbon solvents having eight or more carbon atoms include octane, nonane, decane, dodecane, tridecane, tetradecane, cyclooctane, xylene, mesitylene, ethylbenzene, dodecylbenzene, tetralin, trimethylbenzene cyclohexane, and other nonpolar solvents, and such solvents can be used in combination with other solvents as necessary. Solvents such as mineral spirits and solvent naphtha, which are solvent mixtures, can also be used together with other solvents.

Any kind of solvent can be used as long as it allows the silver particles to disperse in a stable manner and form a good silver-particle layer (M1) on the electrically insulating substrate (A) or on the below-described primer layer (B) formed on the electrically insulating substrate (A). One solvent or two or more in combination can be used.

The silver particle content of the liquid dispersion of silver particles is adjusted so that the amount of the silver-particle layer (M1) formed on the electrically insulating substrate (A), formed using any of various coating processes such as listed above, will be in the range of 0.01 to 0.5 g/m², and can be adjusted according to the selected coating process to give the liquid dispersion a viscosity that maximizes its coating suitability. Preferably, the silver particle content is in a range of 0.05% to 30% by mass, more preferably 0.2% to 20% by mass, even more preferably 0.5% to 10% by mass.

Preferably, the liquid dispersion of silver particles is one in which the silver particles remain dispersed in a stable manner, without aggregating or fusing together or precipitating, for a long period of time in the selected solvent, and preferably contains a dispersant for the silver particles to disperse in the solvent. For such purposes, dispersants having a functional group that becomes coordinated to the silver particles are preferred. Examples include dispersants having functional groups such as the carboxyl group, the amino group, the cyano group, the acetoacetyl group, phosphorus-containing groups, the thiol group, the thiocyanato group, and the glycinato group.

The dispersant can be a commercially available or independently synthesized dispersant having a low or high molecular weight. An appropriate dispersant can be selected according to the purpose, such as the solvent in which the silver particles are dispersed and the type of electrically insulating substrate (A) to be coated with the liquid dispersion of silver particles. For example, compounds such as dodecanethiol, 1-octanethiol, triphenylphosphine, dodecylamine, polyethylene glycol, polyvinylpyrrolidone, polyethyleneimine, and polyvinylpyrrolidone; fatty acids, such as myristic acid, octanoic acid, and stearic acid; and carboxyl-bearing polycyclic hydrocarbon compounds, such as cholic acid, glycyrrhizic acid, and abietic acid, are suitable for use. If the silver-particle layer (M1) is formed on the primer layer (B) described below, it is preferred to use a compound that has a reactive functional group [Y] that can bind with the reactive functional group [X] the resin with which the primer layer (B) is made. This leads to good adhesion between the two layers.

Examples of compounds that have a reactive functional group [Y] include those compounds having groups such as the amino group, the amide group, the alkylolamide group, the carboxyl group, the carboxylic anhydride group, the carbonyl group, the acetoacetyl group, the epoxy group, alicyclic epoxy groups, the oxetane ring, the vinyl group, the allyl group, the (meth)acryloyl group, the (blocked) isocyanate group, and the (alkoxy)silyl group and silsesquioxane compounds. It is particularly preferred that the reactive functional group [Y] be a group that contains a basic nitrogen atom because this helps further improve the adhesion between the primer layer (B) and the silver-particle layer (M1). Examples of groups that contain a basic nitrogen atom include the imino, primary amino, and secondary amino groups.

There may be one or multiple groups that contain a basic nitrogen atom in each molecule of the dispersant. Preferably, the dispersant contains multiple basic nitrogen atoms because in this case part of the basic nitrogen-containing groups contributes to stable dispersion of the silver particles by interacting with the silver particles, and the rest contributes to improving adhesion to the electrically insulating substrate (A). If the primer layer (B) described below is made with a resin having a reactive functional group [X], furthermore, the basic nitrogen-containing groups in the dispersant bind with this reactive functional group [X], thereby helping further improve the adhesion of the conductor-circuit layer (M2) described below onto the electrically insulating substrate (A).

Preferably, the dispersant is a polymeric dispersant. Polymeric dispersants are advantageous to the stability of and the ease of coating with the liquid dispersion of silver particles and helps form a strongly adhering silver-particle layer (M1) on the electrically insulating substrate (A). This polymeric dispersant is preferably, for example, a polyalkyleneimine, such as polyethyleneimine or polypropyleneimine, or an adduct of a polyalkyleneimine with a polyoxyalkylene.

The adduct of a polyalkyleneimine with a polyoxyalkylene may be a product of linear-chain binding of polyethyleneimine and a polyoxyalkylene or may be a product of grafting backbone polyethyleneimine with pendant polyoxyalkylenes.

Specific examples of adducts of a polyalkyleneimine with a polyoxyalkylene include block copolymers of polyethyleneimine and polyoxyethylene, a product of introducing the polyoxyethylene structure to backbone polyethyleneimine by adding ethylene oxide to part of the imino groups therein, and products of reaction between amino groups in a polyalkyleneimine, hydroxy groups in polyoxyethylene glycol, and epoxy groups in an epoxy resin.

Examples of commercially available polyalkyleneimines include "PAO 2006W," "PAO 306," "PAO 318," and "PAO 718," available as Nippon Shokubai Co., Ltd.'s "EPOMIN^{®} PAO polymers."

Preferably, the number-average molecular weight of the polyalkyleneimine is in a range of 3,000 to 30,000.

Preferably, the amount of dispersant required to disperse the silver particles is in a range of 0.01 to 50 parts by mass per 100 parts by mass of the silver particles. Alternatively, it is preferred that the required amount of dispersant be in a range of 0.1 to 10 parts by mass per 100 parts by mass of the silver particles because this helps form a strongly adhering silver-particle layer (M1) on the electrically insulating substrate (A) or the primer layer (B) described below. More preferably, the required amount of dispersant is in a range of 0.1 to 5 parts by mass. This additionally helps improve the ease of plating of the silver-particle layer (M1).

It is not critical how to produce the liquid dispersion of silver particles; various processes can be used to produce it. For example, silver particles produced using a gas-phase process, such as low-vacuum evaporation, may be dispersed in a solvent, or a silver compound may be reduced in a liquid phase to give a liquid dispersion of silver particles directly. Optionally, the solvent makeup of the liquid dispersion, whether prepared by a gas-phase or liquid-phase process, can be changed before coating by solvent exchange and/or adding an extra solvent as needed. Of the gas-phase and liquid-phase processes, liquid-phase processes are particularly suitable for use because of the stability of the resulting liquid dispersion and the simplicity and convenience of the production process. An example of a liquid-phase process is to produce the liquid dispersion by reducing silver ions in the presence of a polymeric dispersant as described above.

The liquid dispersion of silver particles may further contain surfactants, leveling agents, viscosity modifiers, film-forming agents, defoamers, preservatives, and other organic compounds as necessary.

Examples of surfactants include nonionic surfactants, such as polyoxyethylene nonyl phenyl ether, polyoxyethylene lauryl ether, polyoxyethylene styryl phenyl ether, polyoxyethylene sorbitol tetraoleate, and polyoxyethylene-polyoxypropylene copolymers; anionic surfactants, such as sodium oleate and other salts of fatty acids, alkyl sulfates, alkylbenzene sulfonates, alkyl sulfosuccinates, naphthalene sulfonate, polyoxyethylene alkyl sulfates, sodium alkane sulfonates, and sodium alkyl diphenyl ether sulfonates; and cationic surfactants, such as alkylamine salts, alkyltrimethylammonium salts, and alkyldimethylbenzylammonium salts.

For leveling agents, commonly used leveling agents can be used. Examples include silicone compounds, acetylene diol compounds, fluorine compounds.

For viscosity modifiers, commonly used thickening agents can be used. Examples include acrylic polymers and synthetic rubber latex, which thicken the system when the pH is adjusted into the alkaline range, and urethane resins, hydroxyethyl cellulose, carboxymethyl cellulose, methyl cellulose, polyvinyl alcohol, hydrated castor oil, amide waxes, polyethylene oxide, metal soaps, and dibenzylidene sorbitol, which thicken the system through molecular association.

For film-forming agents, commonly used film-forming agents can be used. Examples include sodium dioctyl sulfosuccinate and other anionic surfactants, sorbitan monooleate and other hydrophobic nonionic surfactants, polyether-modified siloxanes, and silicone oils.

For defoamers, commonly used defoamers can be used. Examples include silicone defoamers, nonionic surfactants, polyethers, higher alcohols, and polymeric surfactants.

For preservatives, commonly used preservatives can be used. Examples include isothiazolinone preservatives, triazine preservatives, imidazole preservatives, pyridine preservatives, azole preservatives, and pyrithione preservatives.

The present invention has a more preferred embodiment, which is a method in which before the formation of the silver-particle layer (M1) on the electrically insulating substrate (A), a primer layer (B) is formed on the electrically insulating substrate (A), and then the silver-particle layer (M1) is formed on this layer (step 1'). This method in which a primer layer is formed is advantageous in that it helps further improve the adhesion of the conductor-circuit layer (M2) to the electrically insulating substrate (A).

The primer layer (B) can be formed by coating part or all of the surface of the electrically insulating substrate (A) with a primer and removing the solvent, such as an aqueous medium or organic solvent, contained in the primer. Here, the primer is used to improve the adhesion of the conductor-circuit layer (M2) to the electrically insulating substrate (A) and is a liquid composition obtained by dissolving or dispersing any of resins as described below in a solvent.

It is not critical how to coat the electrically insulating substrate (A) with the primer as long as a good primer layer (B) can be formed; an appropriate method can be selected from various coating processes, for example according to the shape, size, and degree of rigidity or flexibility of the electrically insulating substrate (A) used. Specific examples of coating processes include gravure coating, offset coating, flexo coating, pad printing, gravure offset coating, relief printing, double-sided relief printing, screen printing, microcontact printing, reverse printing, air-doctor coating, blade coating, air-knife coating, squeeze coating, impregnated coating, transfer-roll coating, kiss coating, cast coating, spray coating, inkjet printing, die coating, spin coating, bar coating, and dip coating.

Coating of both sides of a film-, sheet-, or plate-shaped electrically insulating substrate (A) with the primer can be by any method that gives a good primer layer (B); an appropriate method can be selected from such coating processes as listed by way of example above. The primer layer (B) in this case may be formed on both sides of the electrically insulating substrate (A) simultaneously or may be formed on one side of the electrically insulating substrate (A) first and then on the other side. If the electrically insulating substrate (A) is an article having a solid shape, processes such as spray coating, inkjet printing, and dip coating are suitable, although the manufacturer can select an appropriate method from such coating processes as listed by way of example above according to the size and shape of the article.

Before being coated with the primer (step 1'), the electrically insulating substrate (A) may undergo a surface treatment for the purposes of improved coating with the primer and improved adhesion of the conductor-circuit layer (M2) to the substrate. The surface treatments for the electrically insulating substrate (A) that can be used are the same as in the formation of the silver-particle layer (M1) on the electrically insulating substrate (A) described above.

After the surface of the electrically insulating substrate (A) is coated with the primer, the solvent in the coating layer is removed to form the primer layer (B). An example of an ordinary way to do this is to evaporate the solvent by drying the coating layer in a drying oven. The drying temperature can be set to any temperature at which the solvent evaporates and the electrically insulating substrate (A) suffers no adverse effects, and either drying at room temperature or drying by heating works. Specifically, the drying temperature is preferably in a range of 20°C to 350°C, more preferably 60°C to 300°C. The duration of drying is preferably in a range of 1 to 200 minutes, more preferably 1 to 60 minutes.

The drying may involve blowing air or may not involve blowing air. The drying may be carried out in the air, may be carried out in an atmosphere purged with or under a stream of an inert gas, such as nitrogen or argon, or may be carried out in a vacuum.

If the electrically insulating substrate (A) is a piece of film, sheet, or plate or an article having a solid shape, the drying can be by blowing air or carried out inside a drying oven, such as a temperature-controlled oven, as well as by air drying in the place where the coating is carried out. If the electrically insulating substrate (A) is a roll of film or a roll of sheet material, the drying can be by continuously moving the roll material inside an unheated or heated space placed after the coating step.

The thickness of the primer layer (B) can be selected to be appropriate for the specifications and purpose of use of the printed wiring board produced using the present invention. Preferably, the thickness of the primer layer (B) is in a range of 10 nm to 30 µm, more preferably 10 nm to 1 µm, even more preferably 10 nm to 500 nm. This helps further improve the adhesion between the electrically insulating substrate (A) and the conductor-circuit layer (M2).

If the silver particles are dispersed using a dispersant having a reactive functional group [Y], it is preferred that the primer layer (B) be formed by a resin that has a reactive functional group [X] that reacts with the reactive functional group [Y]. Examples of reactive functional groups [X] include the amino group, the amide group, the alkylolamide group, the carboxyl group, the carboxylic anhydride group, the carbonyl group, the acetoacetyl group, the epoxy group, alicyclic epoxy groups, the oxetane ring, the vinyl group, the allyl group, the (meth)acryloyl group, the (blocked) isocyanate group, and the (alkoxy)silyl group. Silsesquioxane compounds can also be used to form the primer layer (B).

In particular, if the reactive functional group [Y] in the dispersant is a group that contains a basic nitrogen atom, it is preferred that the resin forming the primer layer (B) be one that has a carboxyl, carbonyl, acetoacetyl, epoxy, alicyclic epoxy, alkylolamide, isocyanate, vinyl, (meth)acryloyl, or allyl group as a reactive functional group [X]. This helps further improve the adhesion of the conductor-circuit layer (M2) on the electrically insulating substrate (A).

Examples of resins that can be used to form the primer layer (B) include urethane resins, acrylic resins, core-shell composite resins formed by a shell urethane resin and a core acrylic resin, epoxy resins, imide resins, amide resins, melamine resins, phenolic resins, urea formaldehyde resins, blocked isocyanates, which are obtained by reacting a polyisocyanate with phenol or some other blocking agent polyvinyl alcohol, and polyvinyl pyrrolidone. A core-shell composite resin formed by a shell urethane resin and a core acrylic resin can be obtained by, for example, polymerizing an acrylic monomer in the presence of a urethane resin. One such resin or two or more in combination can be used.

Of such resins that can be used to form the primer layer (B), resins that produce a reducing compound upon heating are particularly preferred. They help further improve the adhesion of the conductor-circuit layer (M2) onto the electrically insulating substrate (A). Examples of reducing compounds include phenolic compounds, aromatic amine compounds, sulfur compounds, phosphoric acid compounds, and aldehyde compounds. Of these reducing compounds, phenolic compounds and aldehyde compounds are particularly preferred.

A primer made with a resin that produces a reducing compound upon heating yields a reducing compound, such as formaldehyde or phenol, during a drying and heating step carried out in the formation of the primer layer (B). Specific examples of resins that produce a reducing compound upon heating include resins that produce formaldehyde upon heating, such as resins obtained by polymerizing a monomer containing an N-alkylol(meth)acrylamide, core-shell composite resins formed by a shell urethane resin and a core resin obtained by polymerizing a monomer containing an N-alkylol(meth)acrylamide, urea-formaldehyde-methanol condensates, urea-melamine-formaldehyde-methanol condensates, poly N-alkoxymethylol(meth)acrylamides, formaldehyde adducts of poly(meth)acrylamide, and melamine resins; and resins that produce a phenolic compound upon heating, such as phenolic resins and phenol-blocked isocyanates. Of these resins, core-shell composite resins formed by a shell urethane resin and a core resin obtained by polymerizing a monomer containing an N-alkylol(meth)acrylamide, melamine resins, and phenol-blocked isocyanates are particularly preferred for improved adhesion.

It should be noted that in the present invention, "(meth)acrylamide" refers to one or both of "methacrylamide" and "acrylamide." "(Meth)acrylic acid" refers to one or both of "methacrylic acid" and "acrylic acid." "(Meth)acrylate" refers to one or both of "methacrylate" and "acrylate."

A resin that produces a reducing compound upon heating can be obtained by polymerizing, for example by radical polymerization, anionic polymerization, or cationic polymerization, a monomer having a functional group that produces a reducing compound upon heating.

Examples of monomers having a functional group that produces a reducing compound upon heating include N-alkylol vinyl monomers, specifically N-methylol(meth)acrylamide, N-methoxymethyl(meth)acrylamide, N-ethoxymethyl(meth)acrylamide, N-propoxymethyl(meth)acrylamide, N-isopropoxymethyl(meth)acrylamide, N-n-butoxymethyl(meth)acrylamide, N-isobutoxymethyl(meth)acrylamide, N-pentoxymethyl(meth)acrylamide, N-ethanol (meth)acrylamide, and N-propanol (meth)acrylamide.

In preparing this resin that produces a reducing compound upon heating, the monomer having a functional group that produces a reducing compound upon heating, for example, can be copolymerized with other monomers, such as an alkyl (meth)acrylate.

If a blocked isocyanate is used as a resin for forming the primer layer (B), it forms the primer layer (B) by reacting within itself, i.e., through reaction between its isocyanate groups, forming uretdione bonds or through binding between its isocyanate groups and a functional group of another component. The bonds formed in this process may be formed before the coating with the liquid dispersion of silver particles or may not be formed before the coating with the liquid dispersion of silver particles but be formed by heating after the coating with the liquid dispersion of silver particles.

Examples of blocked isocyanates include those having a functional group formed by the blocking of their isocyanate groups by a blocking agent.

Preferably, the blocked isocyanate is one having such a functional group in a range of 350 to 600 g/mol per mol of the blocked isocyanate.

Preferably, the blocked isocyanate is one that has one to ten such functional groups, more preferably two to five, per molecule for improved adhesion.

Preferably, the number-average molecular weight of the blocked isocyanate is in a range of 1,500 to 5,000, more preferably 1,500 to 3,000, for improved adhesion.

Furthermore, for further improved adhesion, it is preferred that the blocked isocyanate be one that has an aromatic ring. Examples of aromatic rings include the phenyl group and the naphthyl group.

A blocked isocyanate can be produced by reacting part or all of isocyanate groups of an isocyanate compound with a blocking agent.

Examples of isocyanate compounds that can be used as raw materials for a blocked isocyanate include polyisocyanate compounds having an aromatic ring, such as 4,4'-diphenylmethane diisocyanate, 2,4'-diphenylmethane diisocyanate, carbodiimide-modified diphenylmethane diisocyanate, crude diphenylmethane diisocyanate, phenylene diisocyanate, tolylene diisocyanate, and naphthalene diisocyanate; and aliphatic polyisocyanate compounds or polyisocyanate compounds having an alicyclic structure, such as hexamethylene diisocyanate, lysine diisocyanate, cyclohexane diisocyanate, isophorone diisocyanate, dicyclohexylmethane diisocyanate, xylylene diisocyanate, and tetramethylxylylene diisocyanate. Also included are biurets, isocyanurates, and adducts of such polyisocyanate compounds.

Furthermore, products of reacting any of the polyisocyanate compounds listed by way of example above with, for example, a compound having a hydroxy or amino group are also examples of raw-material isocyanate compounds.

If an aromatic ring is introduced into the blocked isocyanate, it is preferred to use a polyisocyanate compound having an aromatic ring. Of polyisocyanate compounds having an aromatic ring, 4,4'-diphenylmethane diisocyanate, tolylene diisocyanate, the isocyanurate of 4,4'-diphenylmethane diisocyanate, and the isocyanurate of tolylene diisocyanate are particularly preferred.

Examples of blocking agents used to produce a blocked isocyanate include phenolic compounds, such as phenol and cresol; lactam compounds, such as ε-caprolactam, δ-valerolactam, and γ-butyrolactam; oxime compounds, such as formamide oxime, acetaldoxime, acetone oxime, methyl ethyl ketoxime, methyl isobutyl ketoxime, and cyclohexanone oxime; and 2-hydroxypyridine, butyl cellosolve, propylene glycol monomethyl ether, benzyl alcohol, methanol, ethanol, n-butanol, isobutanol, dimethyl malonate, diethyl malonate, methyl acetoacetate, ethyl acetoacetate, acetylacetone, butyl mercaptan, dodecyl mercaptan, acetanilide, acetamide, succinimide, maleimide, imidazole, 2-methylimidazole, urea, thiourea, ethyleneurea, diphenylaniline, aniline, carbazole, ethyleneimine, polyethyleneimine, 1H-pyrazole, 3-methylpyrazole, and 3,5-dimethylpyrazole. Of these, blocking agents that dissociate and produce isocyanate groups upon heating in a range of 70°C to 200°C are particularly preferred, more preferably those that produce isocyanate groups that dissociate upon heating in a range of 110°C to 180°C. Specifically, phenolic compounds, lactam compounds, and oxime compounds are preferred. Phenolic compounds, in particular, are more preferred than the others because they ensure that the blocking agent turns into a reducing compound when eliminated by heating.

The production of the blocked isocyanate can be, for example, by mixing an isocyanate compound prepared beforehand with a blocking agent and allowing them to react together or by mixing raw materials for the production of an isocyanate compound with a blocking agent and allowing them to react together.

In more specific terms, the blocked isocyanate can be produced by reacting a polyisocyanate compound with a compound having a hydroxy or amino group to give an isocyanate compound having a terminal isocyanate group, then mixing the isocyanate compound with a blocking agent, and allowing them to react together.

Preferably, the percentage of the blocked isocyanate obtained in this way to the resin(s) forming the primer layer (B) is in a range of 50% to 100% by mass, more preferably 70% to 100% by mass.

Examples of melamine resins include mono- or polymethylol melamine produced by adding 1 to 6 moles of formaldehyde to each mole of melamine; etherified derivatives of (poly)methylol melamine (to any degree of etherification), such as trimethoxymethylol melamine, tributoxymethylol melamine, and hexamethoxymethylol melamine; and urea-melamine-formaldehyde-methanol condensates.

Instead of using a resin that produces a reducing agent upon heating as described above, a reducing compound may be added to a resin. Examples of reducing compounds added in this case include phenolic antioxidants, aromatic-amine antioxidants, sulfur antioxidants, phosphoric-acid antioxidants, vitamin C, vitamin E, sodium ethylenediaminetetraacetate, sulfites, hypophosphoric acid, hypophosphites, hydrazine, formaldehyde, sodium borohydride, dimethylamine borane, and phenol.

In the present invention, using a resin that produces a reducing compound upon heating is preferred over adding a reducing compound to a resin. The latter can affect electrical characteristics because it eventually leaves low-molecular-weight components and ionic compounds.

Preferably, the percentage of the resin in the primer used to form the primer layer (B) is 1% to 70% by mass, more preferably 1% to 20% by mass, for easier coating and better film formation.

Examples of solvents that can be used in the primer include organic solvents and aqueous media. Examples of organic solvents include toluene, ethyl acetate, methyl ethyl ketone, and cyclohexanone. Examples of aqueous media include water, organic solvents miscible with water, and mixtures thereof.

Examples of organic solvents miscible with water include alcohol solvents, such as methanol, ethanol, n-propanol, isopropanol, ethyl carbitol, ethyl cellosolve, and butyl cellosolve; ketone solvents, such as acetone and methyl ethyl ketone; alkylene glycol solvents, such as ethylene glycol, diethylene glycol, and propylene glycol; polyalkylene glycol solvents, such as polyethylene glycol, polypropylene glycol, and polytetramethylene glycol; and lactam solvents, such as N-methyl-2-pyrrolidone.

Optionally, the resin used to form the primer layer (B) may have functional groups that contribute to crosslinking reaction, such as alkoxysilyl, silanol, hydroxy, or amino groups. The crosslink structure formed using these functional groups may have already been formed as early as before the subsequent step of forming the silver-particle layer (M1), or may be formed at any point after the step of forming the silver-particle layer (M1). If the crosslink structure is formed at any point after the step of forming the silver-particle layer (M1), the crosslink structure may have been formed in the primer layer (B) before the formation of the conductor-circuit layer (M2) or may be formed in the primer layer (B), for example by aging, after the formation of the conductor-circuit layer (M2).

Optionally, the primer layer (B) may be used with known additives as necessary, from crosslinking agents to pH-modifying agents, agents that help form a coating, leveling agents, thickening agents, water repellents, and defoamers.

Examples of crosslinking agents include metal chelate compounds, polyamine compounds, aziridine compounds, metal salt compounds, and isocyanate compounds. Examples include thermal crosslinking agents that react and form a crosslink structure at relatively low temperatures of approximately 25°C to 100°C, thermal crosslinking agents that react and form a crosslink structure at relatively high temperatures of 100°C or above, such as melamine compounds, epoxy compounds, oxazoline compounds, carbodiimide compounds, and blocked isocyanate compounds, and photocrosslinking agents.

The amount of crosslinking agent used varies by type, but preferably is in a range of 0.01 to 60 parts by mass in a total of 100 parts by mass of resins in the primer for improved adhesion of the conductor-circuit layer (M2) onto the substrate. More preferably, the amount of crosslinking agent used is 0.1 to 10 parts by mass, even more preferably 0.1 to 5 parts by mass.

If a crosslinking agent is used, the crosslink structure may have been formed as early as before the subsequent step of forming the silver-particle layer (M1), or may be formed at any point after the step of forming the silver-particle layer (M1). If the crosslink structure is formed at any point after the step of forming the silver-particle layer (M1), the crosslink structure may be formed in the primer layer (B) before the formation of the conductor-circuit layer (M2) or may be formed in the primer layer (B), for example by aging, after the formation of the conductor-circuit layer (M2).

The formation of the silver-particle layer (M1) on the primer layer (B) in step 1' of the present invention is the same as the formation of the silver-particle layer (M1) on the electrically insulating substrate (A).

Like the electrically insulating substrate (A), the primer layer (B) may undergo a surface treatment for the purposes of improved coating with the liquid dispersion of silver particles and improved adhesion of the conductor-circuit layer (M2) to the substrate before being coated with the liquid dispersion of silver particles.

In step 2 of the present invention, a patterned resist is formed on the silver-particle layer (M1). The patterned resist is a resist patterned by removing the portion thereof in the area in which the circuit is to be formed (also referred to as the circuit area). It is not critical how to form the patterned resist; known methods can be used to form it. A resist layer is formed either by applying a liquid photosensitive resist to the silver-particle layer (M1) and drying the applied resist or by bonding a photosensitive dry resist to the substrate with the silver-particle layer (M1) thereon by heat pressing using a laminator. Before the formation of the resist, the surface of the silver-particle layer (M1) may be treated for improved adhesion to the resist layer, for example by cleaning with an acidic or alkaline cleaner, corona treatment, plasma treatment, UV treatment, gas-phase ozonation, liquid-phase ozonation, or treatment with a surface treatment agent. One such surface treatment or two or more in combination can be carried out.

Examples of treatments with a surface treatment agent that can be used include the treatment described in Japanese Unexamined Patent Application Publication No. 7-258870, which uses a rust preventive consisting of a triazole compound, a silane coupling agent, and an organic acid, the treatment described in Japanese Unexamined Patent Application Publication No. 2000-286546, which uses an organic acid, a benzotriazole rust preventive, and a silane coupling agent, the treatment described in Japanese Unexamined Patent Application Publication No. 2002-363189, which uses a substance having a structure in which a nitrogen-containing heterocycle, such as triazole or thiadiazole, and a silyl group, such as a trimethoxysilyl or triethoxysilyl group, are bound together by an organic group having a thioether (sulfide) bond, the treatment described in WO 2013/186941, which uses a silane compound that has a triazine ring and an amino group, the treatment described in Japanese Unexamined Patent Application Publication No. 2015-214743, which uses an imidazole silane compound obtained by reacting a formyl imidazole compound and an aminopropylsilane compound together, the treatment described in Japanese Unexamined Patent Application Publication No. 2016-134454, which uses an azole silane compound, the treatment described in Japanese Unexamined Patent Application Publication No. 2017-203073, which is treatment with a solution containing an aromatic compound having an amino group and an aromatic ring in one molecule, a polybasic acid having two or more carboxyl groups, and a halide ion, and the treatment described in Japanese Unexamined Patent Application Publication No. 2018-16865, which is treatment with a surface treatment agent containing a triazole silane compound.

Then a circuit pattern is created on the resist layer formed on the silver-particle layer (M1) by exposure to active light through a photomask or using a direct imager. An appropriate and necessary amount of exposure can be selected. The exposure to light produces a latent image on the resist layer, and removing this latent image using a developer gives a patterned resist.

An example of a developer is a dilute aqueous solution of an alkaline, for example 0.3% to 2% by mass sodium carbonate or potassium carbonate. The dilute aqueous solution of an alkaline may contain surfactants and defoamers, and may contain a small amount of organic solvent or similar substance to accelerate development. The development is carried out by immersing the substrate exposed to light into the developer or spraying the resist with the developer, for example using a sprayer. Through this development, a patterned resist, from which its portion corresponding to the circuit to be formed has been removed, can be formed.

When forming the patterned resist, the manufacturer may additionally remove resist residues, such as skirts of resist formed at the boundaries between the cured resist and the substrate and adhering resist remaining on the surface of the substrate, by plasma descumming or using a commercially available resist-residue remover.

The resist used to form the patterned resist in the present invention can be a commercially available resist ink, liquid resist, or dry-film resist. An appropriate resist can be selected, for example according to the intended resolution of the pattern, the type of imager used, and the type and pH of the chemical used in the subsequent step of plating.

Examples of commercially available resist inks include Taiyo Ink Mfg. Co., Ltd.'s "MA-830 plating resist" and "X-87 etching resist"; NAZDAR's etching resists and plating resists; and GOO Chemical Co., Ltd.'s "PLAS FINE PER etching resists" and "PLAS FINE PPR plating resists." Examples of electrodeposited resists include The Dow Chemical Company's "EAGLE photoresists" and "PEPPER photoresists." Examples of commercially available dry films include Hitachi Chemical Company Ltd.'s "PHOTEC" films; Nikko Materials Co., Ltd.'s "ALPHO" films; Asahi Kasei Corporation's "Sunfort" films, and DuPont's "Riston" films.

If a neutral to acidic plating solution is used, it is easy and convenient to use a dry film resist. In particular, if a fine-pitch circuit is formed, a dry film for the semi-additive process can be used. Examples of commercially available dry films for this purpose include Nikko Materials Co., Ltd.'s "ALFO LDF500" and "NIT2700"; Asahi Kasei Corporation's "Sunfort UFG-258"; Hitachi Chemical Company Ltd.'s "RD films (RD-2015 and 1225)" and "RY films (RY-5319 and 5325)," and DuPont's "PlateMaster films (PM200 and 300)."

If an alkaline plating solution, such as an electroless copper plating solution, is used, the resist is of the type that is peeled off by dissolving it in a solvent. Alternatively, a resist of the type that is peeled off with an alkaline may be used in pH and temperature ranges in which the resist does not peel off.

In step 3 of the present invention, a conductor-circuit layer (M2) is formed, by plating, on the portion of the silver-particle layer (M1) exposed by development as described above.

Before the formation of a conductor-circuit layer (M2) by plating in step 3, the surface of the silver-particle layer (M1) may optionally be treated. Examples of surface treatments here include cleaning with an acidic or alkaline cleaner, corona treatment, plasma treatment, UV treatment, gas-phase ozonation, liquid-phase ozonation, and treatment with a surface treatment agent, all under conditions that do not damage the surface of the silver-particle layer (M1) or the resist pattern formed. One such surface treatment or two or more in combination can be carried out.

The treatment by plating can be by electroless plating with the silver-particle layer (M1) serving as a plating catalyst or a combination of electroless and electrolytic plating.

If the conductor-circuit layer (M2) is formed by electroless plating, examples of plating metals include copper, nickel, chromium, cobalt, cobalt-tungsten, cobalt-tungsten-boron, and tin. Of these metals, copper is employed in accordance with the invention by virtue of its low electrical resistance. In the present invention, the conductor-circuit layer (M2) may be formed by electroless plating and subsequent electrolytic plating. The use of electrolytic plating is advantageous because it boosts production efficiency by helping accelerate the buildup of the plating.

If in step 3 the conductor-circuit layer (M2) is formed by a combination of electroless and electrolytic plating, the metal deposited in the electroless plating and that in the electrolytic plating may be the same or different. Examples include combinations such as electroless copper plating followed by electrolytic copper plating, electroless nickel plating followed by electrolytic copper plating, and electroless cobalt plating followed by electrolytic copper plating. In the present invention, the primary metal used to form the conductor-circuit layer (M2) is copper by virtue of its low electrical resistance. It is preferred to combine electroless copper plating with electrolytic nickel plating, electrolytic cobalt plating, or similar electrolytic plating because it helps improve the long-term reliability of the printed wiring board by helping reduce the diffusion of copper into the substrate.

If the conductor-circuit layer (M2) is formed by a combination of electroless and electrolytic plating, furthermore, the manufacturer can select an appropriate and necessary thickness of the electroless plating layer. Preferably, the thickness of the electroless plating layer is 0.1 µm or more, more preferably 0.15 µm or more. This helps ensure electrical conductivity high enough for proper electrolytic plating.

The conductor-circuit layer (M2) is formed by electrolytic plating preferably with empty spaces between silver particles in the silver-particle layer (M1) filled with the metal used to form the conductor-circuit layer (M2). Filling empty spaces between silver particles with the metal used to form the conductor-circuit layer (M2) ensures that in step 4 described below, the silver-particle layer (M1) in the circuit area, which will be under the conductor-circuit layer (M2), will be removed only to a limited extent by an etchant by virtue of the presence of the metal. The silver-particle layer (M1) in the area in which no circuit has been formed, by contrast, will be removed efficiently by the etchant because the absence of the metal forming the conductor-circuit layer (M2) between silver particles will ensure smooth penetration of the etchant into empty spaces therebetween. By such a mechanism, undercuts in the circuit area are reduced. This is advantageous especially if copper is used to form the conductor-circuit layer (M2), because in this case undercuts in the circuit area can be further reduced by using an etchant with reduced potency to etch copper as described below.

In the method according to the present invention for producing a printed wiring board, annealing may be performed after the plating to relax the stress in and improve the strength of the adhesion of the plating film. The annealing may be carried out before the etching in step 4 described below, may be carried out after the etching, or may be carried out before and after the etching.

An appropriate annealing temperature can be selected within the temperature range of 40°C to 300°C according to the thermal resistance of the substrate used and the intended purpose of use. Preferably, the annealing temperature is in a range of 40°C to 250°C, more preferably 40°C to 200°C in order that oxidative degradation of the plating film will be reduced. As for the duration of annealing, 10 minutes to 10 days is good if the temperature is in a range of 40°C to 200°C, and approximately 5 minutes to 10 hours is good for annealing at a temperature above 200°C. If the plating film is annealed, an antirust may optionally be applied to the surface of the plating film before that.

In step 4 of the present invention, the patterned resist is peeled away, and the silver-particle layer (M1) in the area in which no circuit has been formed (also referred to as the no-circuit area) is removed using an etchant. The peeling away of the patterned resist can be carried out under recommended conditions specified in the catalog, written specifications, etc., for the resist used. The resist remover used to peel away the patterned resist can be a commercially available resist remover or a 1.5% to 3% by mass aqueous solution of sodium hydroxide or potassium hydroxide set to 45°C to 60°C. The peeling away of the resist can be achieved either by immersing the substrate with the conductor-circuit layer (M2) thereon into the remover or by spraying the remover, for example using a sprayer.

The etchant used to remove the silver-particle layer (M1) in the no-circuit area contains a carboxylic acid and hydrogen peroxide as active ingredients and the proportions between the carboxylic acid and hydrogen peroxide in the mixture are in a range of 2 to 100 moles of hydrogen peroxide per mole of the carboxylic acid, which is an etchant that selectively etches the silver-particle layer (M1) only and does not etch the conductor-circuit layer (M2). Since the silver-particle layer (M1) contains silver particles, etchants that quickly dissolve silver are preferred.

If the metal forming the conductor-circuit layer (M2) is copper, the etchant is preferably one with which only silver is removed efficiently and copper to a minimum extent when the silver-particle layer (M1) in the no-circuit area is removed in step 4 of the present invention. An example of such an etchant is a mixture of a carboxylic acid and hydrogen peroxide.

Examples of carboxylic acids include acetic acid, formic acid, propionic acid, butyric acid, valeric acid, caproic acid, enanthic acid, caprylic acid, pelargonic acid, capric acid, lauric acid, myristic acid, palmitic acid, margaric acid, stearic acid, oleic acid, linoleic acid, linolenic acid, arachidonic acid, eicosapentaenoic acid, docosahexaenoic acid, oxalic acid, malonic acid, succinic acid, benzoic acid, salicylic acid, phthalic acid, isophthalic acid, terephthalic acid, gallic acid, mellitic acid, cinnamic acid, pyruvic acid, lactic acid, malic acid, citric acid, fumaric acid, maleic acid, aconitic acid, glutaric acid, adipic acid and amino acids. One such carboxylic acid or two or more in combination can be used. Of these carboxylic acids, it is particularly preferred to use acetic acid primarily. Acetic acid can be easily made into an etchant and is easy to handle.

A mixture of a carboxylic acid and hydrogen peroxide used as an etchant, the inventors believe, produces a peroxycarboxylic acid through the reaction of the hydrogen peroxide with the carboxylic acid. The resulting peroxycarboxylic acid presumably dissolves the silver forming the silver-particle layer (M1) preferentially, while dissolving the copper forming the conductor-circuit layer (M2) only to a limited extent.

In the present invention, the proportions between the carboxylic acid and hydrogen peroxide in the mixture are in a range of 2 to 100 moles, more preferably 2 to 50 moles, of hydrogen peroxide per mole of the carboxylic acid. This helps limit the dissolution of the conductor-circuit layer (M2).

Preferably, the mixture of a carboxylic acid and hydrogen peroxide is an aqueous solution, diluted with water. The percentage of the mixture of a carboxylic acid and hydrogen peroxide in the aqueous solution is preferably in a range of 2% to 65% by mass, more preferably 2% to 30% by mass. This helps reduce the effect of increased temperature of the etchant.

As for the water used to dilute the mixture, it is preferred to use water from which ionic substances and impurities have been removed, such as deionized water, purified water, or ultrapure water.

The etchant may further contain a protective agent added to protect the conductor-circuit layer (M2) and thereby to limit the dissolution thereof. If the conductor-circuit layer (M2) is an electrolytic copper plating layer, it is preferred to use an azole compound as a protective agent.

Examples of azole compounds include imidazoles, pyrazoles, triazoles, tetrazoles, oxazoles, thiazoles, selenazoles, oxadiazoles, thiadiazoles, oxatriazoles, and thiatriazoles.

Specific examples of azole compounds include 2-methylbenzimidazole, aminotriazole, 1,2,3-benzotriazole, 4-aminobenzotriazole, 1-bisaminomethylbenzotriazole, aminotetrazole, phenyltetrazole, 2-phenylthiazole, and benzothiazole. One such azole compound or two or more in combination can be used.

Preferably, the concentration of the azole compound in the etchant is in a range of 0.001% to 2% by mass, more preferably 0.01% to 0.2% by mass.

If the conductor-circuit layer (M2) is an electrolytic copper plating layer, furthermore, it is preferred that the etchant contain a polyalkylene glycol added as a protective agent. This helps limit the dissolution of the electrolytic copper plating layer.

Examples of polyalkylene glycols include water-soluble polymers, such as polyethylene glycol, polypropylene glycol, and polyoxyethylene polyoxypropylene block copolymers. Of these, polyethylene glycol is particularly preferred. Preferably, the number-average molecular weight of the polyalkylene glycol is in a range of 200 to 20,000.

The concentration of the polyalkylene glycol in the etchant is preferably in a range of 0.001% to 2% by mass, more preferably 0.01% to 1% by mass.

The etchant may optionally contain a sodium salt, potassium salt, or ammonium salt of an organic acid or a similar additive mixed in to reduce fluctuations in pH.

The removal of the silver-particle layer (M1) in the no-circuit area in step 4 of the present invention can be achieved either by immersing the substrate, with the conductor-circuit layer (M2) thereon and the resist peeled away therefrom, into the etchant or by spraying the substrate with the etchant, for example using a sprayer.

If an etch system is used to remove the silver-particle layer (M1) in the no-circuit area, the etchant may be, for example, prepared to its predetermined composition with all of its ingredients first and then supplied to the etch system. Alternatively, each ingredient of the etchant may be supplied to the etch system first, and then the etchant may be prepared to its predetermined composition inside the system, by mixing the components together there.

Preferably, the etchant is used in a temperature range of 10°C to 35°C. In particular, an etchant that contains hydrogen peroxide is used preferably in a temperature range of 30°C or below. This helps limit the decomposition of the hydrogen peroxide.

In step 4 of the present invention, a cleaning operation other than washing in water may be carried out after the removal of the silver-particle layer (M1) in the no-circuit area using an etchant to prevent silver components dissolved in the etchant from adhering to or remaining on the printed wiring board. Preferably, the cleaning operation is with the use of a cleaning solution that dissolves silver oxide, silver sulfide, and silver chloride but dissolves silver only sparingly. Specifically, it is preferred to use an aqueous solution containing a thiosulfate or tris(3-hydroxyalkyl)phosphine or an aqueous solution containing a mercaptocarboxylic acid or its salt as a cleaning chemical.

Examples of thiosulfates include ammonium thiosulfate, sodium thiosulfate, and potassium thiosulfate. Examples of tris(3-hydroxyalkyl)phosphines include tris(3-hydroxymethyl)phosphine, tris(3-hydroxyethyl)phosphine, and tris(3-hydroxypropyl)phosphine. In each of the categories of thiosulfates and tris(3-hydroxyalkyl)phosphines, one compound such as listed above or two or more in combination can be used.

If an aqueous solution containing a thiosulfate is used, an appropriate concentration can be selected for it, for example according to the process time and the characteristics of the cleaning system used. Preferably, the concentration is in a range of 0.1% to 40% by mass, more preferably 1% to 30% by mass in view of cleaning efficiency and the stability of the chemical in continuous use.

If an aqueous solution containing a tris(3-hydroxyalkyl)phosphine is used, an appropriate concentration can be selected for it, for example according to the process time and the characteristics of the cleaning system used. Preferably, the concentration is in a range of 0.1% to 50% by mass, more preferably 1% to 40% by mass in view of cleaning efficiency and the stability of the chemical in continuous use.

Examples of mercaptocarboxylic acids include thioglycolic acid, 2-mercaptopropionic acid, 3-mercaptopropionic acid, thiomalic acid, cysteine, and N-acetylcysteine. Examples of salts of mercaptocarboxylic acids include alkali metal salts, ammonium salts, and amine salts.

If an aqueous solution of a mercaptocarboxylic acid or its salt is used, the concentration is preferably in a range of 0.1% to 20% by mass. More preferably, the concentration is in a range of 0.5% to 15% by mass in view of cleaning efficiency and the process cost involved in large-scale treatment.

This cleaning operation can be carried out by, for example, immersing the printed wiring board obtained in step 4 into the cleaning solution or spraying the printed wiring board with the cleaning solution, for example using a sprayer. As for the temperature of the cleaning solution, it can be used at room temperature (25°C). The cleaning solution, however, may be used with a temperature setting of, for example, 30°C. This helps ensure that the cleaning is performed in a stable manner, without being influenced by the ambient temperature.

The step of removing the silver-particle layer (M1) in the no-circuit area using an etchant and the cleaning operation in step 4 can be repeated as necessary.

In step 4 of the present invention, the removal of the silver-particle layer (M1) in the no-circuit area using an etchant may optionally be followed by another cleaning operation carried out to further improve electrical insulation in the no-circuit area. This cleaning operation can be with the use of, for example, an alkaline permanganic acid solution prepared by dissolving potassium permanganate or sodium permanganate in an aqueous solution of potassium hydroxide or sodium hydroxide.

The cleaning using an alkaline permanganic acid solution can be by, for example, immersing the printed wiring board obtained in step 4 into an alkaline permanganic acid solution set to 20°C to 60°C or by spraying the printed wiring board with the alkaline permanganic acid solution, for example using an sprayer. Before the cleaning, the printed wiring board may be brought into contact with an water-soluble organic solvent having an alcoholic hydroxy group in order that the alkaline permanganic acid solution will wet the surface of the substrate well and thereby to improve cleaning efficiency. Examples of organic solvents include methyl alcohol, ethyl alcohol, n-propyl alcohol, and isopropyl alcohol. One such organic solvent or two or more in combination can be used.

An appropriate and necessary concentration can be selected for the alkaline permanganic acid solution. Preferably, the alkaline permanganic acid solution is a product of dissolving 0.1 to 10 parts by mass of potassium permanganate or sodium permanganate in 100 parts by mass of a 0.1% to 10% by mass aqueous solution of potassium hydroxide or sodium hydroxide. More preferably, the alkaline permanganic acid solution is a product of dissolving 1 to 6 parts by mass of potassium permanganate or sodium permanganate in 100 parts by mass of a 1% to 6% by mass aqueous solution of potassium hydroxide or sodium hydroxide in view of cleaning efficiency.

If this cleaning using an alkaline permanganic acid solution is carried out, it is preferred that the cleaning with an alkaline permanganic acid solution be followed by treating the cleaned printed wiring board with a liquid having neutralizing/reducing effects. Examples of liquids having neutralizing/reducing effects include 0.5% to 15% by mass dilute sulfuric acids and aqueous solutions containing an organic acid. Examples of organic acids include formic acid, acetic acid, oxalic acid, citric acid, ascorbic acid, and methionine.

This cleaning with an alkaline permanganic acid solution may be carried out after the aforementioned cleaning for preventing silver components dissolved in the etchant from adhering to and remaining on the printed wiring board. Alternatively, the cleaning with an alkaline permanganic acid solution may be performed alone, instead of cleaning the printed wiring board to prevent silver components dissolved in the etchant from adhering to and remaining on it.

A printed wiring board obtained by a production method according to the present invention may optionally be subjected to the formation of a solder resist layer on the circuit pattern and to nickel/gold plating, nickel/palladium/gold plating, or palladium/gold plating as surface finishing for the conductor-circuit layer (M2) as necessary.

The above-described methods according to the present invention for producing a printed wiring board allow the manufacturer to produce a wiring board having circuit wiring that strongly adheres and has a good rectangular cross-sectional shape on various smooth substrates without using vacuum equipment. By using a production method according to the present invention, therefore, manufacturers can well provide high-density and high-performance printed wiring board substrates and printed wiring boards in different shapes and sizes at low cost. Thus the present invention has high industrial applicability in the field of printed wiring boards. The production methods according to the present invention, furthermore, can also be used to produce not only a printed wiring board but also various components that have a patterned metal layer on the surface of a substrate, such as connectors, shields against electromagnetic waves, RFID and other antennas, and film capacitors. In addition, the production methods according to the present invention are also suitable for decorative plating purposes, or to make decorations that have a patterned metal layer on substrates of different shapes and sizes by plating.

### EXAMPLES

The following describes the present invention in detail by examples.

### [Production Example 1: Production of Primer (B-1)]

In a nitrogen-purged vessel equipped with a thermometer, a gaseous nitrogen inlet tube, and a stirrer, 100 parts by mass of a polyester polyol (polyester polyol obtained by reacting 1,4-cyclohexanedimethanol, neopentyl glycol, and adipic acid together), 17.6 parts by mass of 2,2-dimethylolpropionic acid, 21.7 parts by mass of 1,4-cyclohexanedimethanol, and 106.2 parts by mass of dicyclohexylmethane-4,4'-diisocyanate were allowed to react in a solvent mixture of 178 parts by mass of methyl ethyl ketone to give a solution of a urethane prepolymer having a terminal isocyanate group.

Then 13.3 parts by mass of triethylamine was added to the urethane prepolymer solution to neutralize carboxyl groups in the urethane prepolymer. The resulting mixture was stirred thoroughly with 380 parts by mass of water to give an aqueous liquid dispersion of a urethane prepolymer.

The resulting aqueous liquid dispersion of a urethane prepolymer was stirred with 8.8 parts by mass of a 25% by mass aqueous solution of ethylenediamine to extend the chains of the urethane prepolymer. Then the dispersion was aged, and the solvent was removed to give an aqueous liquid dispersion of a urethane resin (non-volatile content, 30% by mass). The weight-average molecular weight of the urethane resin was 53,000.

Then 140 parts by mass of deionized water and 100 parts by mass of the above aqueous liquid dispersion of a urethane resin were put into a reactor equipped with a stirrer, a reflux condenser, a nitrogen inlet tube, a thermometer, a dropping funnel for adding a mixture of monomers, and a dropping funnel for adding a polymerization catalyst, and the temperature was increased to 80°C with nitrogen blown into the reactor. Then, with stirring, a mixture of monomers consisting of 60 parts by mass of methyl methacrylate, 30 parts by mass of n-butyl acrylate, and 10 parts by mass of N-n-butoxymethylacrylamide and 20 parts by mass of a 0.5% by mass aqueous solution of ammonium persulfate were added dropwise from separate dropping funnels over 120 minutes with the temperature inside the reactor kept at 80°C.

After the end of addition, the mixture was stirred for another 60 minutes at the same temperature. Then the temperature inside the reactor was cooled to 40°C, the mixture was diluted with deionized water to a non-volatile content of 20% by mass, and the dilution was filtered through a 200-mesh filter cloth. This gave a water dispersion of a primer-layer resin composition that was a core-shell composite resin having a shell layer formed by the urethane resin and a core layer formed by an acrylic resin made from methyl methacrylate and other monomers. Then this water dispersion was combined and mixed with isopropyl alcohol and deionized water to an isopropanol/water ratio by mass of 7/3 and a non-volatile content of 2% by mass. In this way, primer (B-1) was obtained.

### [Production Example 2: Production of Primer (B-2)]

In a reaction flask equipped with a reflux condenser, a thermometer, and a stirrer, 200 parts by mass of water and 350 parts by mass of methanol were added to 600 parts by mass of formalin containing 37% by mass formaldehyde and 70 by mass methanol. After the pH of this aqueous solution was adjusted to 10 with a 25% by mass aqueous solution of sodium hydroxide, 310 parts by mass of melamine was added. The melamine was hydroxymethylated for 1 hour at an increased solution temperature of 85°C.

Then the pH was adjusted to 7 with formic acid, and etherification (secondary reaction) was induced by cooling the solution to 60°C. The pH was adjusted to 9 with a 25% by mass aqueous solution of sodium hydroxide at the turbidity temperature, 40°C, to terminate the esterification (duration of reaction: 1 hour). The remaining methanol was removed in a reduced-pressure atmosphere at a temperature of 50°C (duration of methanol removal: 4 hours) to give a primer resin composition containing a melamine resin with a non-volatile content of 80% by mass. Then this resin composition was diluted and mixed with methyl ethyl ketone. In this way, primer (B-2) was obtained with a non-volatile content of 2% by mass.

### [Production Example 3: Production of Primer (B-3)]

A reactor equipped with a thermometer, a gaseous nitrogen inlet tube, and a stirrer and purged with nitrogen was charged with 9.2 parts by mass of 2,2-dimethylolpropionic acid, 57.4 parts by mass of polymethylene polyphenyl polyisocyanate (Tosoh Corporation "Millionate MR-200"), and 233 parts by mass of methyl ethyl ketone. The mixture was allowed to react at 70°C for 6 hours to give an isocyanate compound. Then 26.4 parts by mass of phenol as a blocking agent was fed into the reactor and allowed to react at 70°C for 6 hours. Then the reaction was cooled to 40°C to give a solution of a blocked isocyanate.

Then, to the resulting solution of a blocked isocyanate, 7 parts by mass of triethylamine was added at 40°C to neutralize carboxyl groups in the blocked isocyanate. After the solution was stirred thoroughly with water, methyl ethyl ketone was removed by distillation to give a primer-layer resin composition containing a blocked isocyanate and water with a non-volatile content of 20% by mass. Then this resin composition was diluted and mixed with methyl ethyl ketone. In this way, primer (B-3) was obtained with a non-volatile content of 2% by mass.

### [Production Example 4: Production of Primer (B-4)]

Primer (B-4) was obtained by mixing 35 parts by mass of a novolac resin (DIC Corporation "PHENOLITE TD-2131"; hydroxy equivalent weight, 104 g/eq), 64 parts by mass of an epoxy resin (DIC Corporation "EPICLON 850-S"; a bisphenol-A epoxy resin; epoxy equivalent weight, 188 g/eq), and 1 part by mass of 2,4-diamino-6-vinyl-s-triazine (Shikoku Chemicals Corporation "VT") together and then diluting and mixing the mixture with methyl ethyl ketone to a non-volatile content of 2% by mass.

### [Production Example 5: Production of Primer (B-5)]

Primer (B-5) was obtained by mixing 35 parts by mass of a novolac resin (DIC Corporation "PHENOLITE TD-2131"; hydroxy equivalent weight, 104 g/eq), 64 parts by mass of an epoxy resin (DIC Corporation "EPICLON 850-S"; a bisphenol-A epoxy resin; epoxy equivalent weight, 188 g/eq), and 1 part by mass of a silane coupling agent having a triazine ring (Shikoku Chemicals Corporation "VD-5") together and then diluting and mixing the mixture with methyl ethyl ketone to a non-volatile content of 2% by mass.

### [Production Example 6: Production of Primer (B-6)]

To a flask fitted with a thermometer, a condenser, a fractionating column, and a stirrer were added 750 parts by mass of phenol, 75 parts by mass of melamine, 346 parts by mass of 41.5% by mass formalin, and 1.5 parts by mass of triethylamine. The temperature was increased to 100°C with attention paid to heat produced by the reaction. After 2 hours of reaction at 100°C under reflux, the temperature was increased to 180°C over 2 hours at atmospheric pressure while water was removed. Then unreacted phenol was removed at reduced pressure to give an aminotriazine-modified novolac resin. The hydroxy equivalent weight was 120 g/eq.

Sixty-five parts by mass of the resulting aminotriazine novolac resin and 35 parts by mass of an epoxy resin (DIC Corporation "EPICLON 850-S"; a bisphenol-A epoxy resin; epoxy equivalent weight, 188 g/eq) were mixed together, and then the resulting mixture was diluted and mixed with methyl ethyl ketone to a non-volatile content of 2% by mass. In this way, primer composition (B-6) was obtained.

### [Production Example 7: Production of Primer (B-7)]

Primer composition (B-7) was obtained by mixing 48 parts by mass of the aminotriazine novolac resin obtained in Production Example 6 and 52 parts by mass of an epoxy resin (DIC Corporation "EPICLON 850-S"; a bisphenol-A epoxy resin; epoxy equivalent weight, 188 g/eq) together and then diluting and mixing the mixture with methyl ethyl ketone to a non-volatile content of 2% by mass.

### [Production Example 8: Production of Primer (B-8)]

Primer composition (B-8) was obtained with a non-volatile content of 2% by mass as in Production Example 7, except that the amounts of aminotriazine novolac resin and epoxy resin were changed from 48 parts by mass to 39 parts by mass and from 52 parts by mass to 61 parts by mass, respectively.

### [Production Example 9: Production of Primer (B-9)]

Primer composition (B-9) was obtained with a non-volatile content of 2% by mass as in Production Example 8, except that the amounts of aminotriazine novolac resin and epoxy resin were changed from 48 parts by mass to 31 parts by mass and from 52 parts by mass to 69 parts by mass, respectively.

### [Production Example 10: Production of Primer (B-10)]

Primer (B-10) was obtained by mixing 47 parts by mass of the aminotriazine novolac resin obtained in Production Example 7, 52 parts by mass of an epoxy resin (DIC Corporation "EPICLON 850-S"; a bisphenol-A epoxy resin; epoxy equivalent weight, 188 g/eq), and 1 part by mass of trimellitic anhydride together and then diluting and mixing the mixture with methyl ethyl ketone to a non-volatile content of 2% by mass.

### [Production Example 11: Production of Primer (B-11)]

To a reactor equipped with a stirrer, a reflux condenser, a nitrogen inlet tube, a thermometer, and dropping funnels were added 350 parts by mass of deionized water and 4 parts by mass of a surfactant (Kao Corporation "LATEMUL E-118B": 25% by mass active ingredient). The temperature was increased to 70°C with nitrogen blown into the reactor.

A mixture of vinyl monomers consisting of 47.0 parts by mass of methyl methacrylate, 5.0 parts by mass of glycidyl methacrylate, 45.0 parts by mass of n-butyl acrylate, and 3.0 parts by mass of methacrylic acid was mixed with 4 parts by mass of a surfactant (DKS Co., Ltd. "AKUARON (HITENOL) KH-1025": 25% by mass active ingredient) and 15 parts by mass of deionized water to give a monomer preemulsion. Part of this monomer preemulsion (5 parts by mass) and then 0.1 parts by mass of potassium persulfate were added to the reactor with stirring, and the monomers were polymerized for 60 minutes with the temperature inside the reactor kept at 70°C.

Then with the temperature inside the reactor kept at 70°C, the rest of the monomer preemulsion (114 parts by mass) and 30 parts by mass of an aqueous solution of potassium persulfate (1.0% by mass active ingredient) were added dropwise over 180 minutes, using a different dropping funnel for each. After the end of addition, the mixture was stirred for 60 minutes at the same temperature.

The temperature inside the reactor was cooled to 40°C, then deionized water was used to make the non-volatile content 10.0% by mass, and the resulting liquid was filtered through a 200-mesh filter cloth to give a primer-layer resin composition to be used in the present invention. Then this resin composition was diluted and mixed with added water. In this way, primer (B-11) was obtained with a non-volatile content of 5% by mass.

### [Preparation Example 1: Preparation of a Liquid Dispersion of Silver Particles]

A dispersion containing silver particles and a dispersant was prepared by dispersing silver particles having an average diameter of 30 nm in a solvent mixture of 45 parts by mass of ethylene glycol and 55 parts by mass of deionized water using a compound of polyethylene imine with added polyoxyethylene as a dispersant. The resulting dispersion was then combined with deionized water, ethanol, and a surfactant to give a 5% by mass liquid dispersion of silver particles.

### [Preparation Example 2: Preparation of Silver Etchant (1)]

Silver etchant (1) was prepared by adding 2.6 parts by mass of acetic acid and then 50 parts by mass of a 35% by mass aqueous solution of hydrogen peroxide to 47.4 parts by mass of water. The molar ratio between hydrogen peroxide and the carboxylic acid (hydrogen peroxide/carboxylic acid) in silver etchant (1) was 13.6. The percentage of the mixture of hydrogen peroxide and a carboxylic acid in silver etchant (1) was 22.4% by mass.

### [Preparation Example 3: Preparation of Silver Etchant (2)]

Silver etchant (2) was prepared by diluting 100 parts by mass of silver etchant (1), obtained in Preparation Example 2, with 100 parts by mass of water. The molar ratio between hydrogen peroxide and the carboxylic acid (hydrogen peroxide/carboxylic acid) in silver etchant (2) was 13.6. The percentage of the mixture of hydrogen peroxide and a carboxylic acid in silver etchant (2) was 11.2% by mass.

### [Fabrication Example 1: Fabrication of a Polyphenylene Sulfide (PPS) Substrate]

One hundred parts by mass of a linear polyphenylene sulfide (MFR as per ASTM D1238-86: 600 g/10 min) was uniformly mixed with 58.8 parts by mass of chopped glass fiber (Asahi Fiber Glass Co., Ltd. "FT562," a fibrous inorganic filler), 8.4 parts by mass of an ethylene-methacrylic acid copolymer with zinc ions (DuPont Mitsui Chemicals Co., Ltd. "Himilan 1855"), and 0.8 parts by mass of a montanate-based composite wax (Clariant Japan K.K. "Licolub WE40"). The resulting mixture was then melt-kneaded at 290°C to 330°C using a 35-mm-diameter twin-screw extruder to give a polyphenylene sulfide resin composition. The resulting polyphenylene sulfide resin composition was shaped using an injection molding machine to give a PPS substrate having a size of 50 mm × 105 mm × 2 mm.

### (Example 1)

A silver-particle layer was formed on the surface of a polyimide film (Du Pont-Toray Co., Ltd. "Kapton 150EN-C"; thickness, 38 µm) by coating the surface of the polyimide film with the liquid dispersion of silver particles obtained in Preparation Example 1 using a tabletop small coater (RK PrintCoat Instruments "K Printing Proofer") to a dry coating weight of 0.05 g/m² and then drying the resulting coating at 80°C for 5 minutes using a hot-air dryer.

A dry film resist (Hitachi Chemical Company Ltd. "PHOTEC RD-1225"; resist thickness, 25 µm) was laminated onto the silver-particle layer by pressure bonding at 100°C using a roll laminator, giving a multilayer body having a stack of a silver-particle layer and a photosensitive-resin layer on a polyimide substrate.

With the resulting multilayer body, an L/S = 50/50 µm comb-shaped pattern was created by exposure to light on the resist using a direct-exposure digital imager (Orbotech "Nuvogo 1000R"). Then the pattern was developed using a 1% by mass aqueous solution of sodium carbonate to form a patterned resist, i.e., a resist from which its portion corresponding to the comb-shaped electrode pattern had been removed, on the silver-particle layer and thereby expose the silver-particle layer on the polyimide film.

After 1 hour of aging at 100°C, the substrate with the patterned resist thereon was immersed in an electroless copper plating solution (C. Uyemura & Co., Ltd. "THRU-CUP PEA-6") at 36°C for 10 minutes to form an electroless copper plating film (thickness, 0.4 µm). Then, with the surface of the resulting electroless copper plating set on the cathode and phosphorus-containing copper as the anode, the substrate was subjected to 20 minutes of electrolytic plating at a current density of 2.5 A/dm² using an electrolytic plating solution containing copper sulfate (copper sulfate, 70 g/L; sulfuric acid, 200 g/L; chloride ions, 50 mg/L; and an additive (Okuno Chemical Industries Co., Ltd. "TOP LUCINA SF-M") to form comb-shaped electrodes as a conductor-circuit layer (thickness, 10 µm) of electrolytic copper plating in the area of the resist from which its patterned portion had been removed. Then the patterned resist was peeled away by immersing the film with the conductor-circuit layer of copper thereon in a 3% by mass aqueous solution of sodium hydroxide set to 50°C.

Then the silver-particle layer was removed except in the area of the comb-shaped electrodes by immersing the above film in silver etchant (1), obtained in Preparation Example 2, at 25°C for 30 seconds, completing a printed wiring board. The cross-sectional shape of the circuit portion (comb-shaped electrode portion) of the resulting printed wiring board was rectangular with no undercut.

### (Example 2)

A multilayer body having a stack of a silver-particle layer and a photosensitive-resin layer on a polyimide film was prepared as in Example 1, except that the dry weight of the silver-particle layer was changed from 0.05 g/m² to 0.3 g/m². By immersing a film with a patterned resist removed therefrom in silver etchant (1), obtained in Preparation Example 2, at 25°C for 3 minutes as in Example 1, comb-shaped electrodes were formed as a conductor-circuit layer of copper on the polyimide film, completing a printed wiring board. The cross-sectional shape of the circuit portion (comb-shaped electrode portion) of the resulting printed wiring board was rectangular with no undercut.

### (Example 3)

A primer layer was formed on the surface of a polyimide film (Du Pont-Toray Co., Ltd. "Kapton 150EN-C"; thickness, 38 µm) by coating the surface of the polyimide film with primer (B-1), obtained in Production Example 1, using a tabletop small coater (RK PrintCoat Instruments "K Printing Proofer") to a dry thickness of 100 nm and then drying the resulting coating at 80°C for 5 minutes using a hot-air dryer.

Then a silver-particle layer containing silver particles was formed on the surface of the primer layer by coating the surface of the primer layer with the liquid dispersion of silver particles obtained in Preparation Example 1 using a tabletop small coater (RK PrintCoat Instruments "K Printing Proofer") to a dry coating weight of 0.1 g/m² and then drying the resulting coating at 200°C for 30 minutes using a hot-air dryer. After the formation of the silver-particle layer, the same process as in Example 2 was followed to obtain a printed wiring board. The cross-sectional shape of the circuit portion (comb-shaped electrode portion) of the resulting printed wiring board was rectangular with no undercut.

### (Examples 4 to 13)

A printed wiring board was obtained as in Example 3, except that the primer for the primer layer, the conditions for its drying, the thickness of the silver-particle layer (M1), and the etchant were changed to those indicated in Table 1 or 2. The cross-sectional shape of the circuit portion (comb-shaped electrode portion) of the resulting printed wiring board was rectangular with no undercut.

### (Example 14)

A multilayer body having a stack of a primer layer, a silver-particle layer, and a photosensitive-resin layer on a polyimide substrate was prepared, and a patterned resist was formed as a resist with a portion corresponding to an L/S = 50/50 µm comb-shaped pattern removed thereon as in Example 13.

After 1 hour of aging at 100°C, a 0.2-µm thick nickel-boron plating layer was formed by immersing the multilayer body with the patterned resist thereon in an electroless nickel-boron plating solution (Okuno Chemical Industries Co., Ltd. "TOP CHEMALLOY 66-LF") at 65°C for 2 minutes.

Then the surface of the resulting electroless nickel plating was set on the cathode, and thereafter the same process as in Example 3 was followed to obtain a printed wiring board. The cross-sectional shape of the circuit portion (comb-shaped electrode portion) of the resulting printed wiring board was rectangular with no undercut.

### (Example 15)

A multilayer body having a stack of a primer layer, a silver-particle layer, and a photosensitive-resin layer on a polyimide substrate was prepared, and, using this multilayer body, a resist with an L/S = 50/50 µm comb-shaped pattern thereon was formed to expose the silver-particle layer on the primer layer as in Example 13.

Three parts by mass of palladium chloride and 17 parts by mass of 36% by mass hydrochloric acid were dissolved in 80 parts by mass of deionized water to give an aqueous solution containing palladium ions and an acid, and this solution was set to 45°C. Then by immersing the above film, with silver nanoparticles exposed thereon, in this aqueous solution of palladium ions, part of the silver particles was replaced with palladium.

Then an electroless copper plating film (thickness, 0.4 µm) was formed by immersing this substrate in an electroless copper plating solution (C. Uyemura & Co., Ltd. "THRU-CUP PEA-6") at 36°C for 8 minutes. Then the surface of the resulting electroless copper plating was set on the cathode, and thereafter the same process as in Example 13 was followed to obtain a printed wiring board. The cross-sectional shape of the circuit portion (comb-shaped electrode portion) of the resulting printed wiring board was rectangular with no undercut.

### (Example 16)

A multilayer body was prepared, a resist with an L/S = 50/50 µm comb-shaped pattern thereon was formed to expose a silver-particle layer on a primer layer, and the multilayer body was immersed in an aqueous solution of palladium ions as described above to replace part of silver particles with palladium as in Example 15.

An electroless nickel plating film (thickness, 100 nm) was immersing this multilayer body in an electroless nickel plating solution (JCU Corporation "ELFSEED ES-500") at 40°C for 5 minutes. After 10 minutes of drying at 150°C, degreasing (immersion in JCU Corporation's "ELFSEED ES-600" at 25°C for 30 seconds) and acid activation (immersion in JCU Corporation's "ELFSEED ES-PDC" at 25°C for 1 minute) were carried out. The surface of the electroless nickel plating was set on the cathode, and thereafter the same process as in Example 13 was followed to obtain a printed wiring board. The cross-sectional shape of the circuit portion (comb-shaped electrode portion) of the resulting printed wiring board was rectangular with no undercut.

### (Example 17)

The PPS substrate obtained in Fabrication Example 1 was used. A primer-resin layer (thickness, 130 nm) was formed on the PPS substrate by immersing the PPS substrate in primer (B-11), obtained in Production Example 11, for 10 seconds, removing and allowing the substrate to stand for 1 minute, and then drying it at 80°C for 5 minutes using a hot-air dryer.

The liquid dispersion of silver particles obtained in Preparation Example 1 was diluted with deionized water and ethanol to make the ratio by mass between the solvents after dilution 1:1 (water:ethanol) and the concentration of silver particles 1% by mass. A 0.1 g/m² silver-particle layer was formed on the primer layer by immersing the PPS substrate with the primer layer thereon in this liquid for 10 seconds, removing and allowing the PPS substrate to stand for 1 minute, and then drying it at 80°C for 5 minutes using a hot-air dryer.

A dry film resist (Hitachi Chemical Company Ltd. "PHOTEC RD-1225"; resist thickness, 25 µm) was laminated onto the silver-particle layer by pressure bonding at 100°C using a vacuum laminator, giving a multilayer body having a stack of a primer layer, a silver-particle layer, and a photosensitive-resin layer on a PPS substrate.

With the resulting multilayer body, the same process as in Example 1 was repeated to create an L/S = 50/50 µm comb-shaped pattern on the resist and to develop the pattern using a 1% by mass aqueous solution of sodium carbonate and thereby form a patterned resist on the silver-particle layer as a resist from which its portion corresponding to the comb-shaped electrode pattern had been removed.

Then, with the silver-particle layer set as the cathode and phosphorus-containing copper as the anode, the multilayer body was subjected to 20 minutes of electrolytic plating at a current density of 2.5 A/dm² using an electrolytic plating solution containing copper sulfate (copper sulfate, 70 g/L; sulfuric acid, 200 g/L; chloride ions, 50 mg/L; and an additive (Okuno Chemical Industries Co., Ltd. "TOP LUCINA SF-M") to form comb-shaped electrodes as a conductor-circuit layer (thickness, 10 µm) of electrolytic copper plating in the area of the resist from which its patterned portion had been removed. Then the patterned resist was peeled away by immersing the PPS substrate with the conductor-circuit layer of copper thereon in a 3% by mass aqueous solution of sodium hydroxide set to 50°C.

Then the silver-particle layer was removed except in the area of the comb-shaped electrodes by immersing the above film in silver etchant (1), obtained in Preparation Example 2, at 25°C for 3 minutes, completing a printed wiring board. The cross-sectional shape of the circuit portion (comb-shaped electrode portion) of the resulting printed wiring board was rectangular with no undercut.

### (Comparative Example 1)

A 16% by mass water dispersion of copper particles having an average diameter of 108 nm as measured by dynamic light scattering was obtained in accordance with Synthesis Example 36 in International Publication No. 2014/045972. This water dispersion was combined with isopropanol to give a 5% by mass liquid dispersion of copper particles, and the surface of a polyimide film was coated with this liquid dispersion to an average dry thickness of 60 nm as in Example 1. Then a seed layer for plating containing copper particles was formed on the surface of the polyimide film by drying the coating at 200°C for 30 minutes under a nitrogen stream using a hot-air dryer. After the formation of the seed layer for plating, the same process as in Example 1 subsequent to the formation of a silver-particle layer was followed to form a conductor-circuit layer of copper in a comb-shaped electrode pattern on the seed layer for plating.

Then the resulting printed wiring board was immersed in a 10% by mass aqueous solution of sodium persulfate for 5 minutes. As well as the seed layer for plating except the comb-shaped electrodes, the conductor-circuit layer in the lower part of the comb-shaped electrodes was etched. The etching of the conductor-circuit layer was such that undercuts occurred and resulted in partial detachment of the comb-shaped electrodes.

### (Comparative Example 2)

A polyimide film (Du Pont-Toray Co., Ltd. "Kapton 150EN-C"; thickness, 38 µm) was degreased by immersing it in a conditioner solution (JCU Corporation "ELFSEED ES-100 process cleaner") set to 50°C for 2 minutes, and then the surface of the polyimide film was modified by immersing and treating the film in a surface modifier solution (JCU Corporation "ELFSEED ES-200 process modifier") at 50°C for 20 seconds. The surface-modified polyimide film was catalyzed by immersing it in an activator solution (JCU Corporation "ELFSEED ES-300 process activator") at 50°C for 2 minutes and then reduced by treatment with an accelerator solution (JCU Corporation "ELFSEED ES-400 process accelerator") at 35°C for 2 minutes. Then the film was immersed in an electroless copper plating solution (C. Uyemura & Co., Ltd. "THRU-CUP PEA-6") at 36°C for 5 minutes to form an electroless copper plating film (thickness, 0.2 µm) and thereby to form a seed layer for plating of electroless copper plating on the polyimide.

After the formation of the seed layer for plating, the same process as in Example 1 was followed to form a resist with a comb-shaped electrode pattern, to form comb-shaped electrodes as a conductor-circuit layer of copper (thickness, 10 µm) by electrolytic copper plating, and to peel away the resist to complete a printed wiring board.

Then the resulting printed wiring board was immersed in a 10% by mass aqueous solution of sodium persulfate for 5 minutes. The seed layer for plating, made of electroless copper plating, was removed except for the comb-shaped electrode pattern, causing the yellow surface of the polyamide to be seen. An examination of the cross-sectional shape of the circuit portion (comb-shaped electrode portion) revealed that etching proceeded at the boundary between the seed layer for plating and the conductor-circuit layer, with undercuts observed under the comb-shaped electrode pattern. It was also found that the solution also etched the top of the circuit portion, and the etching of this portion was such that the circuit portion no longer maintained its rectangular cross-sectional shape.

### (Comparative Example 3)

A conductor-circuit layer of copper in a comb-shaped electrode pattern was formed on a seed layer for plating made of copper foil as in Example 1 in the same way as in Example 1, except that a commercially available FCCL having a 3-µm thick roughened copper foil as a seed layer for plating (Ube Exsymo Co., Ltd. "UPISEL N-BE1310YSB") was used instead of a Kapton film with a silver-particle layer thereon.

Then the resulting printed wiring board was immersed for 10 minutes in a 10% by mass aqueous solution of sodium persulfate, which is used for etching of a copper seed. The conductor-circuit layer as the comb-shaped electrode portion (circuit portion) became thinner as a result of etching. Along with this, the conductor-circuit layer no longer maintained its rectangular cross-sectional shape, deforming into a half cylinder.

### (Comparative Example 4)

A seed layer for plating was formed on a polyimide film (Du Pont-Toray Co., Ltd. "Kapton 150EN-C"; thickness, 38 µm) by sputter deposition of nickel/chromium (thickness, 30 nm; nickel/chromium ratio by mass = 80/20) and then 70 nm of copper instead of forming a silver-particle layer. After the formation of the seed layer for plating, the same process as in Example 1 was followed to form a conductor-circuit layer of copper in a comb-shaped electrode pattern on the seed layer for plating.

Then the resulting printed wiring board was immersed for 10 minutes in a 10% by mass aqueous solution of sodium persulfate, which is used for etching of a copper seed. The conductor-circuit layer as the comb-shaped electrode portion (circuit portion) became thinner as a result of etching. Along with this, the copper was etched at the boundary with the nickel/chromium layer, and the etching of the copper was such that the wiring no longer maintained its rectangular cross-sectional shape because of undercuts. In the region excluding the comb-shaped electrodes, only the copper layer was removed, and the nickel/chromium layer was not removed but remained.

### (Comparative Example 5)

A multilayer body having a 0.2-µm thick electroless nickel-boron plating layer on its entire surface was prepared as in Example 14, but without a dry film resist on the silver-particle layer. The resulting multilayer body was immersed in silver etchant (1), obtained in Preparation Example 1, at 25°C for 10 minutes. A multimeter, however, indicated electrical continuity on the surface, indicating that the nickel layer was not successfully removed by the etching process.

The printed wiring boards obtained in Examples 1 to 17 and Comparative Examples 1 to 4 above were tested by a multimeter check for the electrical continuity and measurement of the insulation resistance between wires, measurement of the insulation resistance in the no-circuit area, measurement of the peel strength, a check for undercuts, and the examination of the cross-sectional shape of the circuit portion as follows. The board in Comparative Example 4, in which the formation of a comb-shaped electrode pattern failed, was tested only for electrical continuity between wires.

### [Measurement of the Insulation Resistance between Wires]

The printed wiring boards obtained were tested for electrical continuity between the comb-shaped electrodes opposite each other with a space of 50 µm therebetween using a multimeter (FLUKE "233 Remote Display Digital Multimeter"). Each board was reported as "short-circuiting" if the silver-particle layer had been removed insufficiently and electrical continuity was observed, or as "insulating" if the silver-particle layer has been removed to a sufficient extent and no electrical continuity was observed. Then the printed wiring boards found to have no continuity were subjected to the measurement of the resistance between the 50-µm spaced electrodes using Hioki E.E. Corporation's super megohmmeter (SM-8213) in the same way. A wiring board with a measured resistance exceeding 10⁶ Ω can be considered sufficiently insulating between wires.

### [Measurement of the Insulation Resistance in the No-Circuit Area]

The printed wiring boards obtained were subjected to the measurement of resistance in their no-circuit area (region excluding the wiring portion and from which silver had been removed) at an applied voltage of 100 V using Mitsubishi Chemical Analytic Co., Ltd.'s Hiresta-UP (model MCP-HT450). According to the specifications for the analyzer, an "OVER" resistance reading (overload) indicates that the resistance is at least 9.99 × 10¹³ Ω.

### [Check for Undercuts and Examination of the Cross-Sectional Shape of the Circuit Portion]

The printed wiring boards obtained were examined for undercuts and the cross-sectional shape of their circuit portion by observing a cross-section of their circuit portion at a magnification of 500 to 10,000 under a scanning electron microscope (JEOL "JSM7800").

### [Measurement of Peel Strength]

After the electroless plating In Examples 1 to 17 above, or after the formation of the seed layer for plating in Comparative Examples 1 to 4, a test specimen was prepared by subjecting the conductor-circuit layer to 30 minutes of electrolytic copper plating over its entire surface. The plating was carried out using copper sulfate as in the procedure described above, but without a resist pattern. The resulting test specimen, having a 15-µm thick copper plating layer as a conductor-circuit layer, was subjected to the measurement of peel strength by a 90° peeling test using Seishin Trading Co., Ltd.'s "High Precision Bond Tester SS-30WD."

A summary of measurement results for the printed wiring boards obtained in Examples 1 to 17 and Comparative Examples 1 to 4 is presented in Tables 1 and 2. The abbreviations for etchants represent the following.
A: Silver etchant (1) (percentage of the mixture of hydrogen peroxide and acetic acid: 22.4% by mass)
B: Silver etchant (2) (percentage of the mixture of hydrogen peroxide and acetic acid: 11.2% by mass)
C: A 10% by mass aqueous solution of sodium persulfate

**[Table 1]**

| | Example 1 | Example 2 | Example 3 | Example 4 | Example 5 | Example 6 | Example 7 | Example 8 | Example 9 |
|---|---|---|---|---|---|---|---|---|---|
| Electrically insulating substrate | Polyimide film | Polyimide film | Polyimide film | Polyimide film | Polyimide film | Polyimide film | Polyimide film | Polyimide film | Polyimide film |
| Primer | None | None | B-1 | B-1 | B-2 | B-3 | B-4 | B-5 | B-6 |
| Primer coating method | - | - | Coater | Coater | Coater | Coater | Coater | Coater | Coater |
| Primer drying temperature (°C) | - | - | 80 | 80 | 120 | 120 | 150 | 150 | 150 |
| Primary drying duration (min) | - | - | 5 | 5 | 5 | 5 | 5 | 5 | 5 |
| Amount of silver-particle layer formed (g/m²) | 0.05 | 0.3 | 0.1 | 0.1 | 0.5 | 0.5 | 0.5 | 0.5 | 0.5 |
| Metal replacement | No | No | No | No | No | No | No | No | No |
| Metal for electroless plating | Cu | Cu | Cu | Cu | Cu | Cu | Cu | Cu | Cu |
| Etchant | A | A | A | B | A | A | A | A | A |
| Hydrogen peroxide/carboxylic acid molar ratio | 13.6 | 13.6 | 13.6 | 13.6 | 13.6 | 13.6 | 13.6 | 13.6 | 13.6 |
| Continuity between wires | Insulating | Insulating | Insulating | Insulating | Insulating | Insulating | Insulating | Insulating | Insulating |
| Resistance between wires (Ω) | >10¹¹ | >10¹¹ | >10¹¹ | >10¹¹ | >10¹¹ | >10¹¹ | >10¹¹ | >10¹¹ | >10¹¹ |
| Resistance in the no-circuit area (Ω) | Overload | Overload | Overload | Overload | Overload | Overload | Overload | Overload | Overload |
| Undercuts | No | No | No | No | No | No | No | No | No |
| Cross-sectional shape of the circuit portion | Rectangular | Rectangular | Rectangular | Rectangular | Rectangular | Rectangular | Rectangular | Rectangular | Rectangular |
| 90° peel strength (N/m) | 657 | 617 | 725 | 725 | 760 | 731 | 795 | 761 | 838 |

**[Table 2]**

| | Example 10 | Example 11 | Example 12 | Example 13 | Example 14 | Example 15 | Example 16 | Example 17 |
|---|---|---|---|---|---|---|---|---|
| Electrically insulating substrate | Polyimide film | Polyimide film | Polyimide film | Polyimide film | Polyimide film | Polyimide film | Polyimide film | PPS substrate |
| Primer | B-7 | B-8 | B-9 | B-10 | B-10 | B-10 | B-10 | B-11 |
| Primer coating method | Coater | Coater | Coater | Coater | Coater | Coater | Coater | Immersion |
| Primer drying temperature (°C) | 150 | 150 | 150 | 150 | 150 | 150 | 150 | 200 |
| Primary drying duration (min) | 5 | 5 | 5 | 5 | 5 | 5 | 5 | 5 |
| Amount of silver-particle layer formed (g/m²) | 0.5 | 0.5 | 0.5 | 0.5 | 0.5 | 0.5 | 0.5 | 0.5 |
| Metal replacement | No | No | No | No | No | Pd | Pd | No |
| Metal for electroless plating | Cu | Cu | Cu | Cu | NiB | Cu | NiP | Cu |
| Etchant | A | A | A | A | A | A | A | A |
| Hydrogen peroxide/carboxylic acid molar ratio | 13.6 | 13.6 | 13.6 | 13.6 | 13.6 | 13.6 | 13.6 | 13.6 |
| Continuity between wires | Insulating | Insulating | Insulating | Insulating | Insulating | Insulating | Insulating | Insulating |
| Resistance between wires (Ω) | >10¹¹ | >10¹¹ | >10¹¹ | >10¹¹ | >10¹¹ | >10¹¹ | >10¹¹ | >10¹¹ |
| Resistance in the no-circuit area (Ω) | Overload | Overload | Overload | Overload | Overload | Overload | Overload | Overload |
| Undercuts | No | No | No | No | No | No | No | No |
| Cross-sectional shape of the circuit portion | Rectangular | Rectangular | Rectangular | Rectangular | Rectangular | Rectangular | Rectangular | Rectangular |
| 90° peel strength (N/m) | 730 | 690 | 535 | 723 | 785 | 785 | 785 | 651 |

**[Table 3]**

| | Comparative Example 1 | Comparative Example 2 | Comparative Example 3 | Comparative Example 4 |
|---|---|---|---|---|
| Electrically insulating substrate | Polyimide film | Polyimide film | Polyimide film | Polyimide film |
| Primer | None | None | None | None |
| Primer coating method | - | - | - | - |
| Primer drying temperature (°C) | - | - | - | - |
| Primary drying duration (min) | - | - | - | - |
| Seed layer for plating | Copper particles | Electroless copper plating layer | Roughened copper foil | Nickel chromium/copper |
| Thickness of the seed layer for plating (nm) | 60 | 200 | 3,000 | 30/100 |
| Etchant | C | C | C | C |
| Hydrogen peroxide/carboxylic acid molar ratio | - | - | - | - |
| Continuity between wires | Insulating | Insulating | Insulating | Short-circuiting |
| Resistance between wires (Ω) | >10¹¹ | >10¹¹ | >10¹¹ | Not measured |
| Resistance in the no-circuit area (Ω) | Overload | Overload | Overload | Not measured |
| Undercuts | Yes | Yes | No | Yes |
| Cross-sectional shape of the circuit portion | Not rectangular | Not rectangular | Half cylindrical | Not rectangular |
| 90° peel strength (N/m) | 605 | 620 | 1,580 | 580 |

## Claims

1. A method for producing a printed wiring board having a circuit pattern on an electrically insulating substrate, the method comprising:
step 1, forming a silver-particle layer (M1) in a range of 0.01 to 0.5 g/m² on an electrically insulating substrate (A);
step 2, forming a patterned resist on the silver-particle layer (M1), the patterned resist being a resist patterned by removing a portion thereof in an area in which a circuit is to be formed;
step 3, forming a conductor-circuit layer (M2) by electroless plating, or a combination of electroless and electrolytic plating, and the primary metal used to form the conductor-circuit layer (M2) is copper; and
step 4, peeling away the patterned resist and removing, using an etchant, the silver-particle layer (M1) in an area in which no circuit has been formed, wherein the etchant contains a carboxylic acid and hydrogen peroxide as active ingredients and the proportions between the carboxylic acid and hydrogen peroxide in the mixture are in a range of 2 to 100 moles of hydrogen peroxide per mole of the carboxylic acid.

2. A method for producing a printed wiring board having a circuit pattern on an electrically insulating substrate, the method comprising:
step 1', forming a primer layer (B) on an electrically insulating substrate (A) and then forming a silver-particle layer (M1) in a range of 0.01 to 0.5 g/m² on the primer layer (B);
step 2, forming a patterned resist on the silver-particle layer (M1), the patterned resist being a resist patterned by removing a portion thereof in an area in which a circuit is to be formed;
step 3, forming a conductor-circuit layer (M2) by electroless plating, or a combination of electroless and electrolytic plating, and the primary metal used to form the conductor-circuit layer (M2) is copper; and
step 4, peeling away the patterned resist and removing, using an etchant, the silver-particle layer (M1) in an area in which no circuit has been formed, wherein the etchant contains a carboxylic acid and hydrogen peroxide as active ingredients and the proportions between the carboxylic acid and hydrogen peroxide in the mixture are in a range of 2 to 100 moles of hydrogen peroxide per mole of the carboxylic acid.

3. The method according to Claim 1 or 2 for producing a printed wiring board, wherein the plating is electroless plating.

4. The method according to Claim 1 or 2 for producing a printed wiring board, wherein the plating is a combination of electroless and electrolytic plating.

5. The method according to any one of Claims 1 to 4 for producing a printed wiring board, wherein silver particles forming the silver-particle layer (M1) have been coated with at least one polymeric dispersant.

6. The method according to Claim 5 for producing a printed wiring board, wherein in the method according to Claim 2 for producing a printed wiring board, the primer layer (B) is made with a resin having at least one reactive functional group [X], the polymeric dispersant has a reactive functional group [Y], and the reactive functional group [X] and the reactive functional group [Y] are allowed to bind together.

7. The method according to Claim 6 for producing a printed wiring board, wherein the reactive functional group [Y] is a group that contains a basic nitrogen atom.

8. The method according to Claim 6 for producing a printed wiring board, wherein the polymeric dispersant, having the reactive functional group [Y], is one or more selected from the group consisting of polyalkyleneimines and of polyalkyleneimines having a polyoxyalkylene structure including an oxyethylene unit.

9. The method according to any one of Claims 6 to 8 for producing a printed wiring board, wherein the reactive functional group [X] is one or more selected from the group consisting of a keto group, an acetoacetyl group, an epoxy group, a carboxyl group, an N-alkylol group, an isocyanate group, a vinyl group, a (meth)acryloyl group, and an allyl group.

## Patentansprüche

1. Verfahren zur Herstellung einer Leiterplatte mit einem Schaltungsmuster auf einem elektrisch isolierenden Substrat, wobei das Verfahren umfasst:
Schritt 1: Bilden einer Silberteilchenschicht (M1) in einem Bereich von 0,01 bis 0,5 g/m² auf einem elektrisch isolierenden Substrat (A);
Schritt 2: Bilden eines Schablonenresists auf der Silberteilchenschicht (M1), wobei der Schablonenresist ein Resist ist, der durch Entfernen eines Teils davon in einem Abschnitt, in dem eine Schaltung gebildet werden soll, strukturiert ist;
Schritt 3: Bilden einer Leiterschicht (M2) durch stromloses Plattieren oder eine Kombination aus stromlosem und elektrolytischem Plattieren, wobei das zur Bildung der Leiterbahnschicht (M2) verwendete Primärmetall Kupfer ist; und
Schritt 4, Abziehen des Schablonenresists und Entfernen der Silberteilchenschicht (M1) in einem Abschnitt, in dem kein Schaltkreis gebildet wurde, unter Verwendung eines Ätzmittels, wobei das Ätzmittel eine Carbonsäure und Wasserstoffperoxid als aktive Bestandteile enthält und das Verhältnis zwischen der Carbonsäure und dem Wasserstoffperoxid in der Mischung in einem Bereich von 2 bis 100 Mol Wasserstoffperoxid pro Mol Carbonsäure liegen.

2. Verfahren zur Herstellung einer Leiterplatte mit einem Schaltungsmuster auf einem elektrisch isolierenden Substrat, wobei das Verfahren umfasst:
Schritt 1', Bilden einer Grundierungsschicht (B) auf einem elektrisch isolierenden Substrat (A) und dann Bilden einer Silberteilchenschicht (M1) in einem Bereich von 0,01 bis 0,5 g/m² auf der Grundierungsschicht (B);
Schritt 2: Bilden eines Schablonenresists auf der Silberteilchenschicht (M1), wobei der Schablonenresist ein Resist ist, der durch Entfernen eines Teils davon in einem Abschnitt, in dem eine Schaltung gebildet werden soll, strukturiert ist;
Schritt 3: Bilden einer Leiterschicht (M2) durch stromloses Plattieren oder eine Kombination aus stromlosem und elektrolytischem Plattieren, wobei das zur Bildung der Leiterbahnschicht (M2) verwendete Primärmetall Kupfer ist; und
Schritt 4, Abziehen des Schablonenresists und Entfernen der Silberteilchenschicht (M1) in einem Abschnitt, in dem kein Schaltkreis gebildet wurde, unter Verwendung eines Ätzmittels, wobei das Ätzmittel eine Carbonsäure und Wasserstoffperoxid als aktive Bestandteile enthält und das Verhältnis zwischen der Carbonsäure und dem Wasserstoffperoxid in der Mischung in einem Bereich von 2 bis 100 Mol Wasserstoffperoxid pro Mol Carbonsäure liegen.

3. Verfahren nach Anspruch 1 oder 2 zur Herstellung einer Leiterplatte, wobei das Beschichten ein stromloses Beschichten ist.

4. Verfahren nach Anspruch 1 oder 2 zur Herstellung einer Leiterplatte, wobei das Beschichten eine Kombination aus stromlosem und elektrolytischem Beschichten ist.

5. Verfahren nach einem der Ansprüche 1 bis 4 zur Herstellung einer Leiterplatte, wobei die die Silberteilchenschicht (M1) bildenden Silberteilchen mit zumindest einem polymeren Dispergiermittel beschichtet wurden.

6. Verfahren nach Anspruch 5 zur Herstellung einer Leiterplatte, wobei bei dem Verfahren nach Anspruch 2 zur Herstellung einer Leiterplatte die Grundierungsschicht (B) mit einem Harz hergestellt wird, das zumindest eine reaktive funktionelle Gruppe [X] aufweist, das polymere Dispergiermittel eine reaktive funktionelle Gruppe [Y] aufweist und die reaktive funktionelle Gruppe [X] und die reaktive funktionelle Gruppe [Y] miteinander in Verbindung gebracht werden.

7. Verfahren nach Anspruch 6 zur Herstellung einer Leiterplatte, wobei die reaktive funktionelle Gruppe [Y] eine Gruppe ist, die ein basisches Stickstoffatom enthält.

8. Verfahren nach Anspruch 6 zur Herstellung einer Leiterplatte, wobei das polymere Dispergiermittel mit der reaktiven funktionellen Gruppe [Y] eines oder mehrere ist, ausgewählt aus der Gruppe, bestehend aus Polyalkyleniminen und Polyalkyleniminen mit einer Polyoxyalkylenstruktur, die eine Oxyethyleneinheit beinhaltet.

9. Verfahren nach einem der Ansprüche 6 bis 8 zur Herstellung einer Leiterplatte, wobei die reaktive funktionelle Gruppe [X] eine oder mehrere ist, ausgewählt aus der Gruppe, bestehend aus einer Ketogruppe, einer Acetoacetylgruppe, einer Epoxygruppe, einer Carboxylgruppe, einer N-Alkylolgruppe, einer Isocyanatgruppe, einer Vinylgruppe, einer (Meth)acryloylgruppe und einer Allylgruppe.

## Revendications

1. Procédé de production d'une carte de circuit imprimé ayant un motif de circuit sur un substrat électriquement isolant, le procédé comprenant :
étape 1, la formation d'une couche de particules d'argent (M1) dans une plage de 0,01 à 0,5 g/m² sur un substrat électriquement isolant (A) ;
étape 2, la formation d'un résist à pochoir sur la couche de particules d'argent (M1), le résist à pochoir étant un résist formé en enlevant une partie de celui-ci dans une zone dans laquelle un circuit doit être formé ;
étape 3, la formation d'une couche de circuit conducteur (M2) par placage anélectrolytique, ou une combinaison de placage anélectrolytique et électrolytique, et le métal primaire utilisé pour former la couche de circuit conducteur (M2) est le cuivre ; et
étape 4, le décollement du résist à pochoir et l'enlèvement, à l'aide d'un agent de gravure, de la couche de particules d'argent (M1) dans une zone dans laquelle aucun circuit n'a été formé, dans lequel l'agent de gravure contient un acide carboxylique et du peroxyde d'hydrogène comme ingrédients actifs et les proportions entre l'acide carboxylique et le peroxyde d'hydrogène dans le mélange sont dans une plage de 2 à 100 moles de peroxyde d'hydrogène par mole de l'acide carboxylique.

2. Procédé de production d'une carte de circuit imprimé ayant un motif de circuit sur un substrat électriquement isolant, le procédé comprenant :
étape 1', la formation d'une couche d'apprêt (B) sur un substrat électriquement isolant (A) et puis la formation d'une couche de particules d'argent (M1) dans une plage de 0,01 à 0,5 g/m² sur la couche d'apprêt (B) ;
étape 2, la formation d'un résist à pochoir sur la couche de particules d'argent (M1), le résist à pochoir étant un résist obtenu en enlevant une partie de celui-ci dans une zone dans laquelle un circuit doit être formé ;
étape 3, la formation d'une couche de circuit conducteur (M2) par placage anélectrolytique, ou une combinaison de placage anélectrolytique et électrolytique, et le métal primaire utilisé pour former la couche de circuit conducteur (M2) est le cuivre ; et
étape 4, le décollement du résist à pochoir et l'enlèvement, à l'aide d'un agent de gravure, de la couche de particules d'argent (M1) dans une zone dans laquelle aucun circuit n'a été formé, dans lequel l'agent de gravure contient un acide carboxylique et du peroxyde d'hydrogène comme ingrédients actifs et les proportions entre l'acide carboxylique et le peroxyde d'hydrogène dans le mélange sont comprises dans une plage de 2 à 100 moles de peroxyde d'hydrogène par mole de l'acide carboxylique.

3. Procédé selon la revendication 1 ou 2 pour la production d'une carte de circuit imprimé, dans lequel le placage est un placage anélectrolytique.

4. Procédé selon la revendication 1 ou 2 pour la production d'une carte de circuit imprimé, dans lequel le placage est une combinaison de placage anélectrolytique et électrolytique.

5. Procédé selon l'une quelconque des revendications 1 à 4 pour la production d'une carte de circuit imprimé, dans lequel les particules d'argent formant la couche de particules d'argent (M1) ont été revêtues d'au moins un dispersant polymère.

6. Procédé selon la revendication 5 pour la production d'une carte de circuit imprimé, dans lequel, dans le procédé selon la revendication 2 pour la production d'une carte de circuit imprimé, la couche d'apprêt (B) est réalisée avec une résine ayant au moins un groupe fonctionnel réactif [X], le dispersant polymère a un groupe fonctionnel réactif [Y], et le groupe fonctionnel réactif [X] et le groupe fonctionnel réactif [Y] sont autorisés à se lier.

7. Procédé selon la revendication 6 pour la production d'une carte de circuit imprimé, dans lequel le groupe fonctionnel réactif [Y] est un groupe qui contient un atome d'azote basique.

8. Procédé selon la revendication 6 pour la production d'une carte de circuit imprimé, dans lequel le dispersant polymère, ayant le groupe fonctionnel réactif [Y], est un ou plusieurs dispersants choisis dans le groupe constitué par les polyalkylèneimines et les polyalkylèneimines ayant une structure polyoxyalkylène comportant une unité oxyéthylène.

9. Procédé selon l'une quelconque des revendications 6 à 8 pour la production d'une carte de circuit imprimé, dans lequel le groupe fonctionnel réactif [X] est un ou plusieurs choisis dans le groupe constitué par un groupe céto, un groupe acétoacétyle, un groupe époxy, un groupe carboxyle, un groupe N-alkylol, un groupe isocyanate, un groupe vinyle, un groupe (méth)acryloyle et un groupe allyle.
